# EUROPEAN PATENT APPLICATION

(11) **EP 2 555 001 A1**
(43) Date of publication of application: **06.02.2013**
(21) Application number: 11762309.0
(22) Date of filing: 18.01.2011
(51) Int. Cl.: G01R 1/067, G01R 1/073, H01L 21/66

(54) **CONTACT PROBE, CONTACT PROBE CONNECTING BODY AND METHODS FOR MANUFACTURING SAME**

(30) Priority: 30.03.2010 JP 2010077878; 30.03.2010 JP 2010077877
(71) Applicant: Sumitomo Electric Industries, Ltd., Osaka-shi, Osaka 541-0041 (JP)
(72) Inventor: HIRATA, Yoshihiro, Osaka-shi, Osaka 554-0024 (JP); KAWASE, Kazunori, Osaka-shi, Osaka 554-0024 (JP); NITTA, Koji, Osaka-shi, Osaka 554-0024 (JP); INAZAWA, Shinji, Osaka-shi, Osaka 554-0024 (JP); TOKUDA, Takeshi, Osaka 572-0813 (JP)
(74) Representative: Setna, Rohan P.
(86) International application number: PCT/JP2011/050770
(87) International publication number: WO 2011/122068

(57) **Abstract**

A contact probe, a method of manufacturing a linked body of contact probes, and a method of manufacturing a contact probe, which allow for stable use are provided. Contact probe (10a) includes a contact portion (11) to be brought into contact with an object to be measured, a main body portion (12) connected to the contact portion (11), and a covering portion (14) covering the whole circumference of a cross section of the main body portion (12) in a direction intersecting with an extensional direction, excluding the contact portion (11). The covering portion (14) is of a material having a lower volume resistivity than a volume resistivity of a material of the main body portion (12).

## Description

### TECHNICAL FIELD

The present invention relates to a contact probe, a linked body of contact probes, and manufacturing methods thereof.

### BACKGROUND ART

For measurement of electrical properties of electrical circuits such as a semiconductor tip and a liquid crystal display, a contact probe is used. As such a contact probe, for example, Japanese Patent Laying-Open No. 2006-64511 (Patent Literature 1) describes a metal structure including a contact portion to be in contact with an electrical circuit, a spring portion connected to the contact portion, and a supporting portion supporting the spring portion. Patent Literature 1 also describes that a tip portion located on a tip of the contact portion and to be in direct contact with the electrical circuit has a multilayer structure formed of a spring metal layer and a highly conductive layer.

Further, as a conventional method of manufacturing a contact probe, for example, Japanese Patent Laying-Open No. 2000-162241 (Patent Literature 2) discloses the following steps.

Specifically, a sacrificial layer is formed on a surface of a silicon (Si) substrate. A conductive layer is formed on the sacrificial layer. A photoresist layer is formed on the conductive layer. A photomask is aligned over the photoresist layer and the photoresist layer is exposed with ultraviolet light. On a surface of the photoresist layer, an image formed of grooves in the photoresist is formed (developed). An electroplating step is used to form a large number of contact structures (contact probes) by electrodeposition in the grooves in the photoresist. The photoresist layer is removed. The sacrificial layer is removed by first etching, and the conductive layer is removed from the contact probes by a second etching step so that the contact structures are separated from the Si substrate. Patent Literature 1 describes a manufacturing method in which a large number of contact probes are simultaneously fabricated on a silicon (Si) substrate.

### CITATION LIST

### PATENT LITERATURE

- PTL 1:: Japanese Patent Laying-Open No. 2006-64511
- PTL 2:: Japanese Patent Laying-Open No. 2000-162241

### SUMMARY OF INVENTION

### TECHNICAL PROBLEM

However, the spring metal layer and the highly conductive layer disclosed in Patent Literature 1 above are different in material, and therefore, have a weak adherence at their interface. Further, the contact probe is subjected to a large stress. As a result, the spring metal layer and the highly conductive layer tend to delaminate from each other at their interface. Therefore, the contact probe of Patent Literature 1 above has a problem that the contact probe is unable to allow for stable use.

Further, when a large number of contact probes are manufactured by the manufacturing method in Patent Literature 2 above, contact probes are fabricated as individual pieces. A contact probe is so small that it is difficult to grip. As a result, it is difficult to subject a contact probe in an individual piece to an aftertreatment such as plating and insulative coating. As such, a contact probe manufactured by the manufacturing method in Patent Literature 2 has a problem that the contact probe is difficult to handle.

Furthermore, even if gripping the contact probe is achieved, subjecting the very small contact probe to an aftertreatment results in a very high cost treatment. As a result, a contact probe manufactured by the manufacturing method in Patent Literature 2 above has a problem of high cost.

Therefore, the present invention has been made to solve the problems as above, and an object of the present invention is to provide a contact probe, a linked body of contact probes, and manufacturing methods thereof, which allow for stable use.

Another object of the present invention is to provide a linked body of contact probes, a method of manufacturing a linked body of contact probes, and a method of manufacturing a contact probe, which provide easy handling and reduce costs.

### SOLUTION TO PROBLEM

A contact probe of the present invention includes: a contact portion to be brought into contact with an object to be measured; a main body portion to be connected to the contact portion; and a covering portion covering the whole outer circumference of a cross section of the main body portion in a direction intersecting with an extensional direction, excluding the contact portion. The covering portion is of a material having a lower volume resistivity than a volume resistivity of a material of the main body portion.

According to the contact probe of the present invention, the covering portion covers the whole outer circumference of at least part of the main body portion in a cross section. As a result, even if the contact probe is subjected to a stress, delamination between the main body portion and the covering portion can be suppressed. Further, since the covering portion has a smaller volume resistivity than that of the main body portion, heat generation by contact probe can be suppressed. Therefore, the contact probe of the present invention allows for stable use.

Preferably, in the above-described contact probe, the main body portion is of a nickel alloy. A nickel alloy has an excellent spring characteristic, and therefore, the contact probe of the present invention allows for more stable use.

A linked body of contact probes of the present invention includes: a plurality of contact probes as described above; and a linking member linking the plurality of contact probes together in areas in the plurality of contact probes other than the contact portion and a tip portion opposite the contact portion. In this case, since the linking member has brought the plurality of contact probes into a positioned state, the plurality of contact probes can be integrally handled as a single linked body of contact probes. As a result, improved workability in, for example, processing the contact probe can be achieved.

A method of manufacturing a linked body of contact probes of the present invention includes the steps of: forming, on a substrate, a resin mold having an opening; filling the opening of the mold with a metal material by electroforming; forming a contact portion to be brought into contact with an object to be measured, a main body portion connected to the contact portion, and tip portion located opposite the contact portion in the main body portion, by removing the mold and the substrate; and forming a covering portion to cover the whole outer circumference of a cross section of the main body portion in a direction intersecting with an extensional direction, excluding the contact portion, with a material having a lower volume resistivity than a volume resistivity of the main body portion. In the step of forming the mold, the opening open for a region to form a plurality of contact probes each including the contact portion, the main body portion, and the tip portion and for a region to form a linking member linking the plurality of contact probes together in areas in the plurality of contact probes other than the contact portion and the tip portion is formed.

According to the method of manufacturing a linked body of contact probes of the present invention, the plurality of contact probes on which the covering portion has not been formed are linked together by a link in an area having a small effect on the function of the contact probe, thereby being made into one piece, which is, in this state, larger than an individual contact probe, and thus is easy to handle. For this reason, by forming the covering portion, in this state, a plurality of covering portions covering the whole outer circumference of the main body portion in a cross section except the contact portion can be readily formed. Therefore, the linked body of contact probes in which the plurality of contact probes allowing for stable use are linked together can be manufactured.

Preferably, in the above-described method of manufacturing a linked body of contact probes, the step of forming the covering portion includes the steps of: forming a metal layer by covering the main body portion with the material to form the covering portion; and removing a region in the metal layer other than a region to serve as the covering portion. This enables the covering layer to be readily formed.

Preferably, in the above-described method of manufacturing a linked body of contact probes, the step of forming the covering portion includes the steps of: covering the main body portion with an insulating layer; exposing the main body portion by removing a region where the covering portion is to be formed in the insulating layer; and forming the covering portion on the exposed main body portion. This enables the covering portion to be readily formed.

A method of manufacturing a contact probe of the present invention includes the steps of: manufacturing a linked body of contact probes by any of the above-described methods of manufacturing a linked body of contact probes; and separating the contact probe from a link in the linked body of contact probes.

According to the method of manufacturing a contact probe of the present invention, a contact probe which includes a covering portion covering the whole outer circumference of at least part of the main body portion in a cross section can be manufactured. Therefore, a contact probe allowing for stable use can be manufactured.

A linked body of contact probes of the present invention includes a plurality of contact probes and a linking member. The plurality of contact probes each includes a contact portion to be brought into contact with an object to be measured and a tip portion opposite the contact portion. The linking member links the plurality of contact probes together in areas in the plurality of contact probes other than the contact portion and the tip portion.

A method of manufacturing a linked body of contact probes of the present invention includes the steps of: forming, on a substrate, a resin mold having an opening; filling the opening of the mold with a metal material by electroforming; and removing the mold and the substrate. In the step of forming the mold, the opening open for a region to form a plurality of contact probes each including a contact portion to be brought into contact with an object to be measured and a tip portion opposite the contact portion and for a region to form a linking member linking the plurality of contact probes together in areas in the plurality of contact probes other than the contact portion and the tip portion is formed.

According to the linked body of contact probes and the manufacturing method thereof of the present invention, a link can make the plurality of contact probes into one piece by linking them together in an area having a small effect on the function of the contact probe. The linked body of contact probes is larger than an individual contact probe, and thus is easy to handle. Further, subjecting the linked body of contact probes to an aftertreatment allows for a simple aftertreatment as compared with subjecting the individual contact probes to the aftertreatment, and therefore, costs can be reduced.

In the above-described linked body of contact probes, the linking member can have any specific structure capable of linking the plurality of contact probes together, and there only has to be one linked point.

Preferably, in the above-described linked body of contact probes, the linking member includes holding portions holding at least two points of the outer circumference of each of the plurality of contact probes along one direction intersecting with a direction along which the plurality of contact probes extend.

Preferably, in the above-described method of manufacturing a linked body of contact probes, in the step of forming the mold, the opening is formed such that the linking member includes holding portions holding at least two points of the outer circumference of each of the plurality of contact probes along one direction intersecting with a direction along which the plurality of contact probes extend.

The holding portion enables holding lateral portions of each of the plurality of contact probes from opposing sides. This ensures that the plurality of contact probes and the link are fixed to each other, and therefore, easier handling is provided.

Preferably, in the above-described linked body of contact probes, the linking member includes a plurality of separating portions arranged spaced from each other in parallel and a first connecting portion linking one end of each of the plurality of separating portions together, each of the plurality of contact probes is arranged between corresponding separating portions of the plurality of separating portions, and each of the contact portions or the tip portions opposed to the first connecting portion is arranged spaced from the first connecting portion.

Preferably, in the above-described method of manufacturing a linked body of contact probes, in the step of forming the mold, the opening is formed such that the linking member includes a plurality of separating portions arranged spaced from each other in parallel and a first connecting portion linking one end of each of the plurality of separating portions together; that each of the plurality of contact probes is arranged between corresponding separating portions of the plurality of separating portions; and that each of the contact portions or the tip portions opposed to the first connecting portion is arranged spaced from the first connecting portion.

This can realize the linked body of contact probes which is formed in one piece with the connecting portion while each of the plurality of contact probes is in a state of being separated by the separating portion. As a result, in separating the plurality of contact probes from the linked body of contact probes, separation can be readily achieved.

Preferably, in the above-described linked body of contact probes, the linking member further includes a second connecting portion linking another end of each of the plurality of separating portions together and arranged spaced from the contact portions or the tip portions of the opposed plurality of contact probes.

Preferably, in the above-described method of manufacturing a linked body of contact probes, in the step of forming the mold, the opening is formed such that the linking member further includes a second connecting portion linking another end of each of the plurality of separating portions together and arranged spaced from the contact portions or the tip portions of the opposed plurality of contact probes.

This enables the first and second connecting portions and the separating portion to enclose the plurality of contact probes. As a result, a greater strength of the linked body of contact probes can be achieved. Therefore, separation can be readily achieved in separating the plurality of contact probes from the linked body of contact probes, and easier handling is provided in an aftertreatment.

A method of manufacturing a contact probe of the present invention includes the steps of: manufacturing a linked body of contact probes by any of the above-described methods of manufacturing a linked body of contact probes; and separating the contact probe and the linking member from each other in the linked body of contact probes.

According to the method of manufacturing a contact probe of the present invention, the plurality of contact probes can be manufactured by separating the plurality of contact probes from the linked body of contact probes. Further, in a case where each contact probe is subjected to an aftertreatment, it can be dealt with by a treatment in which the plurality of contact probes in a state of the linked body of contact probes are subjected to the aftertreatment and then separated from the linking member. As a result, easy handling is provided also in an aftertreatment. Further, the plurality of contact probes can be readily separated, and therefore, costs can be reduced.

### ADVANTAGEOUS EFFECTS OF INVENTION

As described above, the contact probe, the method of manufacturing a linked body of contact probes, and the method of manufacturing a contact probe of the present invention can realize a contact probe which allows for stable use.

Further, the linked body of contact probes, the method of manufacturing a linked body of contact probes, and the method of manufacturing a contact probe of the present invention can make handling of contact probes easier and can reduce costs.

### BRIEF DESCRIPTION OF DRAWINGS

Fig. 1 is a plan view schematically showing a contact probe in a first embodiment of the present invention.
Fig. 2 is a cross sectional view along a line II-II in Fig. 1.
Fig. 3 is a plan view schematically showing each step for manufacturing the contact probe in the first embodiment of the present invention.
Fig. 4 is a cross sectional view along a line IV-IV in Fig. 3.
Fig. 5 is a plan view schematically showing each step for manufacturing the contact probe in the first embodiment of the present invention.
Fig. 6 is a cross sectional view along a line VI-VI in Fig. 5.
Fig. 7 is a plan view schematically showing each step for manufacturing the contact probe in the first embodiment of the present invention.
Fig. 8 is a cross sectional view along a line VIII-VIII in Fig. 7.
Fig. 9 is an enlarged view of a region IX in Fig. 7.
Fig. 10 is another enlarged view of the region IX in Fig. 7.
Fig. 11 is another plan view of a step for manufacturing the contact probe in Fig. 7.
Fig. 12 is a plan view schematically showing each step for manufacturing the contact probe in the first embodiment of the present invention.
Fig. 13 is a plan view schematically showing each step for manufacturing contact probe in the first embodiment of the present invention.
Fig. 14 is a plan view schematically showing each step for manufacturing the contact probe in the first embodiment of the present invention.
Fig. 15 is a schematic diagram showing the plating step in the first embodiment of the present invention.
Fig. 16 is a plan view schematically showing each step for manufacturing the contact probe in the first embodiment of the present invention.
Fig. 17 is a cross sectional view along a line XVII-XVII in Fig. 16.
Fig. 18 is a plan view schematically showing each step of manufacturing the contact probe in the first embodiment of the present invention.
Fig. 19 is a plan view schematically showing each step of manufacturing the contact probe in the first embodiment of the present invention.
Fig. 20 is a plan view schematically showing each step of manufacturing a contact probe in a second embodiment of the present invention.
Fig. 21 is a cross sectional view schematically showing each step of manufacturing of the contact probe in the second embodiment of the present invention.
Fig. 22 is a perspective view schematically showing a contact probe in a third embodiment of the present invention.
Fig. 23 is a plan view schematically showing a contact probe in a fourth embodiment of the present invention.
Fig. 24 is a cross sectional view along a line XXIV-XXIV in Fig. 23.
Fig. 25 is a plan view schematically showing a linked body of contact probes in a fifth embodiment of the present invention.
Fig. 26 is a cross sectional view along a line XXVI-XXVI in Fig. 25.
Fig. 27 is an enlarged view of a region XXVII in Fig. 25.
Fig. 28 is another enlarged view of the region XXVII in Fig. 25.
Fig. 29 is a plan view schematically showing a first step for manufacturing the linked body of contact probes in the fifth embodiment of the present invention.
Fig. 30 is a cross sectional view along a line XXX-XXX in Fig. 29.
Fig. 31 is a plan view schematically showing a second step for manufacturing the linked body of contact probes in the present embodiment.
Fig. 32 is a cross sectional view along a line XXXII-XXXII in Fig. 31.
Fig. 33 is a plan view schematically showing a linked body of contact probes in a sixth embodiment of the present invention.
Fig. 34 is a plan view schematically showing a contact probe in a seventh embodiment of the present invention.
Fig. 35 is a plan view showing a step for manufacturing the contact probe in the seventh embodiment of the present invention.
Fig. 36 is a plan view schematically showing a linked body of contact probes 1c in an eighth embodiment of the present invention.
Fig. 37 is a cross sectional view along a line XXXVII-XXXVII in Fig. 36.
Fig. 38 is a schematic diagram showing the plating step in the eighth embodiment of the present invention.
Fig. 39 is a plan view schematically showing a contact probe in a ninth embodiment of the present invention.
Fig. 40 is a plan view schematically showing a linked body of contact probes in a tenth embodiment of the present invention.
Fig. 41 is a cross sectional view along a line XLI-XLI in Fig. 40.
Fig. 42 is a plan view showing a step for manufacturing the linked body of contact probes in the tenth embodiment of the present invention.
Fig. 43 is a plan view showing a step for manufacturing the linked body of contact probes in the tenth embodiment of the present invention.
Fig. 44 is a plan view schematically showing a contact probe in an eleventh embodiment of the present invention.
Fig. 45 is a perspective view schematically showing a contact probe of Comparative Example 2.

### DESCRIPTION OF EMBODIMENTS

Embodiments of the present invention will be described hereinafter with reference to the drawings. In the drawings below, the same or corresponding portions have the same reference characters allotted, and the description thereof will not be repeated.

### First Embodiment

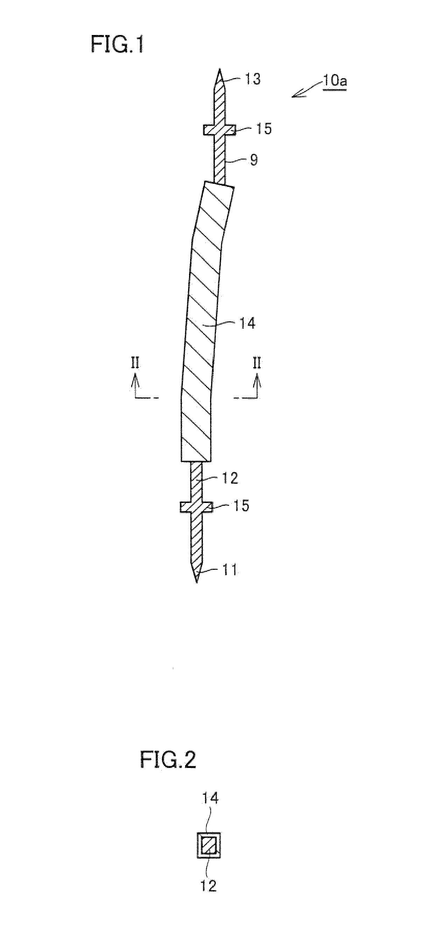

Referring to Figs. 1 and 2, a contact probe 10a in the present embodiment will be described. Contact probe 10a in the present embodiment includes a contact portion 11, a main body portion 12, a tip portion 13, a covering portion 14, and stoppers 15.

Contact portion 11 is to be brought into contact with an object to be measured. Main body portion 12 is connected to contact portion 11. Tip portion 13 is connected to main body portion 12 and located on an end opposite contact portion 11. Tip portion 13 is to be brought into contact with, for example, a connection terminal of an inspection apparatus.

Covering portion 14 covers the whole outer circumference of a cross section of main body portion 12 in a direction intersecting with an extensional direction (the vertical direction in Fig. 1), excluding contact portion 11. In other words, covering portion 14 covers the whole circumference of at least a portion of main body portion 12. In still other words, covering portion 14 envelops the entire outer surface of at least part of main body portion 12 in a cross section. Although covering portion 14 may cover the whole outer circumference of entire main body portion 12, covering portion 14 in the present embodiment covers the whole outer circumference of an area of main body portion 12 in the vicinity of its center.

Covering portion 14 does not cover contact portion 11 because it would obstruct contact. Further, preferably, covering portion 14 also does not cover tip portion 13 for the same reason.

Stoppers 15 are protrusions which are connected from the center side of main body portion 12 to the contact portion 11 side and to the tip portion 13 side, respectively, and protrude in a direction (the lateral direction in Fig. 1) which intersects with a direction along which main body portion 12 extends (the vertical direction in Fig. 1). Stopper 15 is a member for securing contact probe 10a to a jig when the contact probe is pushed onto an object to be measured such as a measured surface of an electrical circuit to measure various electrical properties. That is, stopper 15 supports contact probe 10a to prevent it from moving at the time of measurement.

In the present embodiment, contact portion 11, main body portion 12, tip portion 13, and stopper 15 are formed in one piece. Preferably, a material constituting contact portion 11, main body portion 12, tip portion 13, and stopper 15 includes nickel (Ni), and more preferably, is a nickel alloy. As the nickel alloy, for example, an alloy of Ni and Mn (manganese), an alloy of Ni and W (tungsten), an alloy of Ni and Fe (iron), an alloy ofNi and Co (cobalt), and the like can be used.

Covering portion 14 has a lower volume resistivity than the volume resistivity of main body portion 12. As a result, heat generation by contact probe 10a can be suppressed. Preferably, covering portion 14 has a higher thermal conductivity than the thermal conductivity of main body portion 12. This enables the heat produced at the contact portion to be rapidly released towards the tip portion. As a result, an increase in temperature of contact probe 10a can be suppressed. For these reasons, the upper limit of the current allowed to flow through contact probe 10a (allowable current value) can be improved. As a material of such covering portion 14, for example, copper (Cu), silver (Ag), gold (Au), an alloy thereof, or the like can be used.

Covering portion 14 has a thickness of, for example, not less than 1 µm and not more than 10 µm. With a thickness within this range, a further suppression of delamination of covering portion 14 from main body portion 12 can be achieved, and therefore, a further suppression of heat generation can be achieved.

A method of manufacturing contact probe 10a in the present embodiment will be described in the following with reference to Figs. 1 to 19.

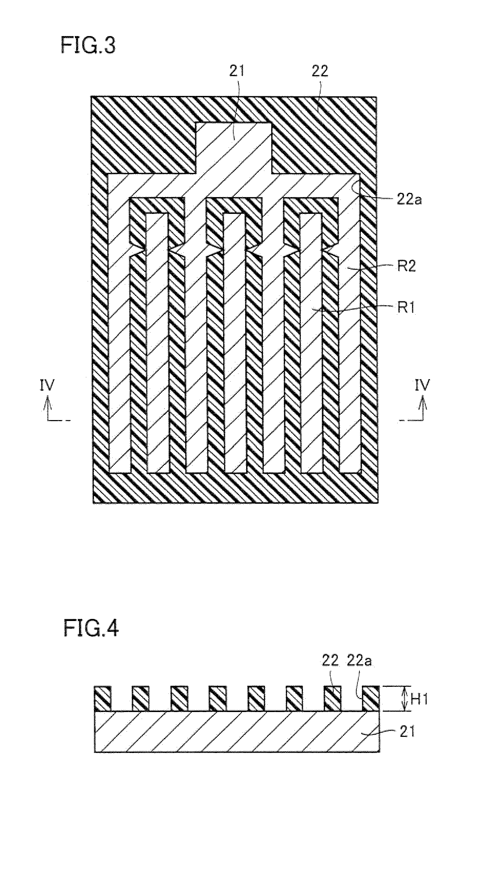

First, as shown in Figs. 3 and 4, a resin mold 22 having an opening 22a is formed on a substrate 21. In this step of forming mold 22, opening 22a open for a region R1 to form a plurality of contact probes and for a region R2 to form a link is formed. In region R1 to form the plurality of contact probes, each contact probe includes contact portion 11 to be brought into contact with an object to be measured, main body portion 12 connected to contact portion 11, and tip portion 13 located opposite contact portion 11 in main body portion 12, as shown in Fig. 1. That is, region R1 to form the plurality of contact probes is a region to form contact probe 10a in Fig. 1 on which covering portion 14 has not been formed. Region R2 to form the link is a region to form a linking member linking the plurality of contact probes together in areas in the plurality of contact probes other than contact portion 11 and tip portion 13.

Specifically, first, substrate 21 is prepared. Substrate 21 is not particularly limited, and for example, a metal substrate of copper (Cu), nickel (Ni), stainless steel such as SUS, aluminum (Al), or the like; an Si substrate to which conductivity is imparted; a glass substrate; or the like can be used. On this substrate 21, a resin layer to serve as resin mold 22 is formed. This resin layer is not particularly limited, and for example, a resist of a resin material primarily composed of polymethacrylic acid ester, an ultraviolet ray (UV) sensitive or X-ray sensitive chemical amplification type resin material, or the like can be used. The thickness of the resin layer (a thickness H1 in Fig. 4) can be set to any thickness according to the thickness of the contact probe to be formed. In the present embodiment, thickness H1 of the resin layer is approximately 10% to 20% thicker than the thickness of the contact probe to be formed, and for example, 40 µm to 70 µm.

Subsequently, a mask having an absorbing layer not allowing light to pass through and a light-transmitting layer allowing light to pass through is arranged on the resin layer. The absorbing layer of the mask has the same shape as that of opening 22a if a positive resist is used. If a negative resist is used as the resin layer, the absorbing layer of the mask has a shape which is the inverse of that of opening 22a. Irradiation of light such as UV ray or X ray through the mask follows. The irradiation of light does not expose the resin layer located under the absorbing layer, and causes the resin layer located under the light-transmitting layer to change in quality. As a result, development removes only the area that has changed in quality (molecular chains are cut) if the resin layer is of a positive resin, and resin mold 22 as shown in Figs. 3 and 4 can be provided.

In this step, region R2 to form the linking member can have any specific structure linked to region R1 to form the plurality of contact probes, and there only has to be one linked point. Preferably, opening 22a is formed such that the linking member includes holding portions holding at least two points of the outer circumference of each of the plurality of contact probes along one direction intersecting with a direction along which the plurality of contact probes extend. Further, opening 22a may be formed such that the linking member includes a plurality of separating portions arranged spaced from each other in parallel and a connecting portion linking one end of each of the plurality of separating portions together; that each of the plurality of contact probes is arranged between corresponding separating portions of the plurality of separating portions; and that contact portion 11 or tip portion 13 opposed to the connecting portion is arranged spaced from the connecting portion.

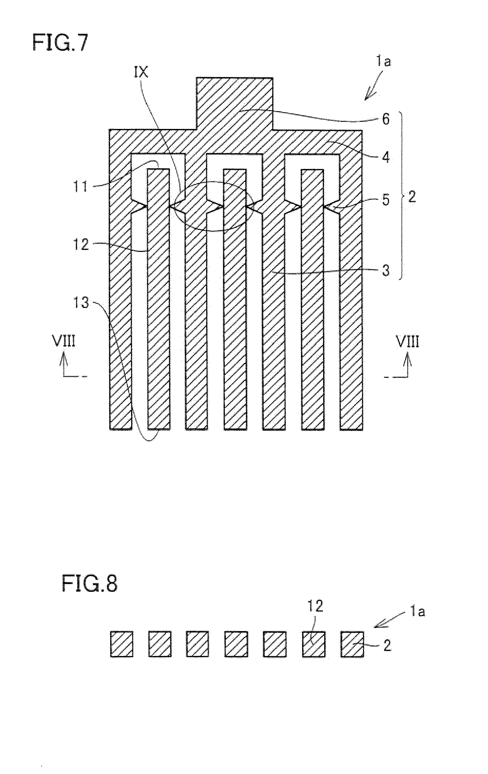

It is noted that a detailed description of the shape of opening 22a will be given when describing the step of forming a linked body of contact probes 1a using Figs. 7 to 10.

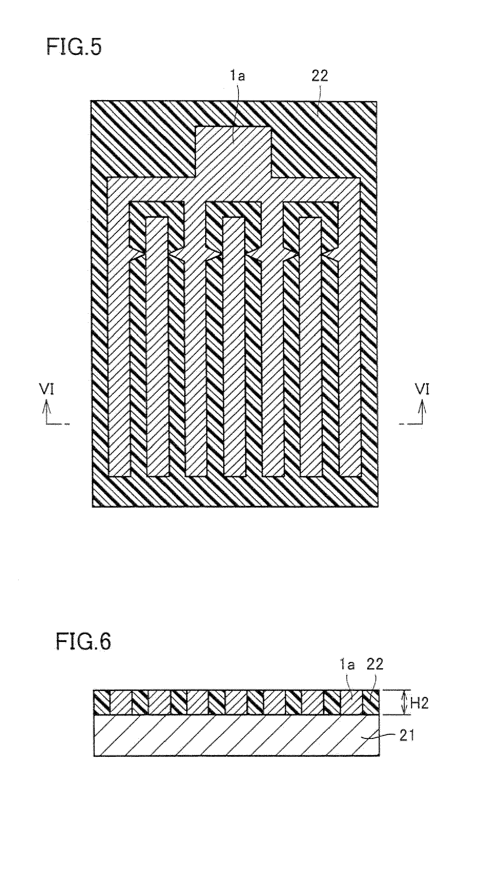

Next, as shown in Figs. 5 and 6, opening 22a of mold 22 is filled with a metal material by electroforming. Specifically, a metal ion solution containing a material to form contact portion 11, main body portion 12, tip portion 13, and stoppers 15 of contact probe 10a shown in Fig. 1 is prepared. Using this metal ion solution, linked body of contact probes 1a made of the metal material is formed in opening 22a of mold 22 on substrate 21. For instance, by electroforming using substrate 21 as a plating electrode, the metal material can be deposited in opening 22a of mold 22. At this time, the metal material is deposited to the extent of filling up opening 22a of mold 22.

Next, the surface of the metal material filled in opening 22a of mold 22 is polished or grinded. As a result, the thickness of the metal material (a thickness H2 in Fig. 6) is adjusted to be the same as the thickness of main body portion 12 of contact probe 10a to be formed. In the present embodiment, the metal material has thickness H2 of, for example, 30 µm to 60 µm.

Next, mold 22 and substrate 21 are removed. As a result, contact portion 11 to be brought into contact with object to be measured, main body portion 12 connected to contact portion 11, and tip portion 13 located opposite contact portion 11 in main body portion can be formed. In the present embodiment, further, stoppers 15 are also formed.

Although a method for the removal of substrate 21 and mold 22 is not particularly limited, for example, mold 22 is removed by wet etching, plasma ashing, or the like. Subsequently, linked body of contact probes 1a is detached from substrate 21. As a result, linked body of contact probes 1a shown in Figs. 7 and 8 can be manufactured.

Now, the structure of linked body of contact probes 1 a will be described. As shown in Figs. 7 and 8, linked body of contact probes 1a includes a plurality of contact probes (contact probes in Fig. 1 on which covering portion 14 has not been formed) and a linking member 2. The plurality of contact probes and linking member 2 are linked together and in one piece. That is, the plurality of contact probes are interlinked through linking member 2.

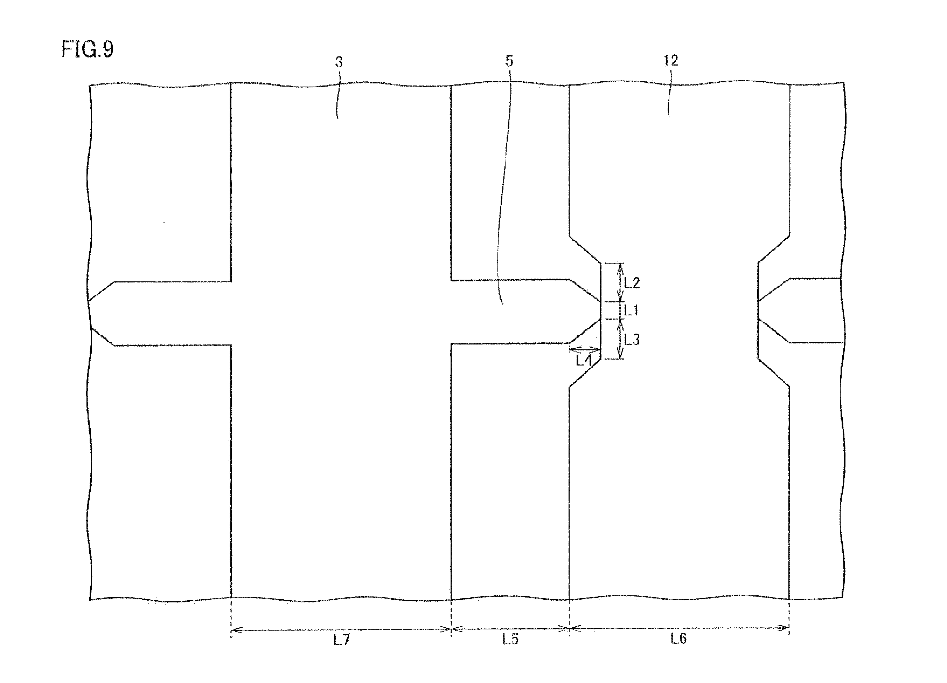

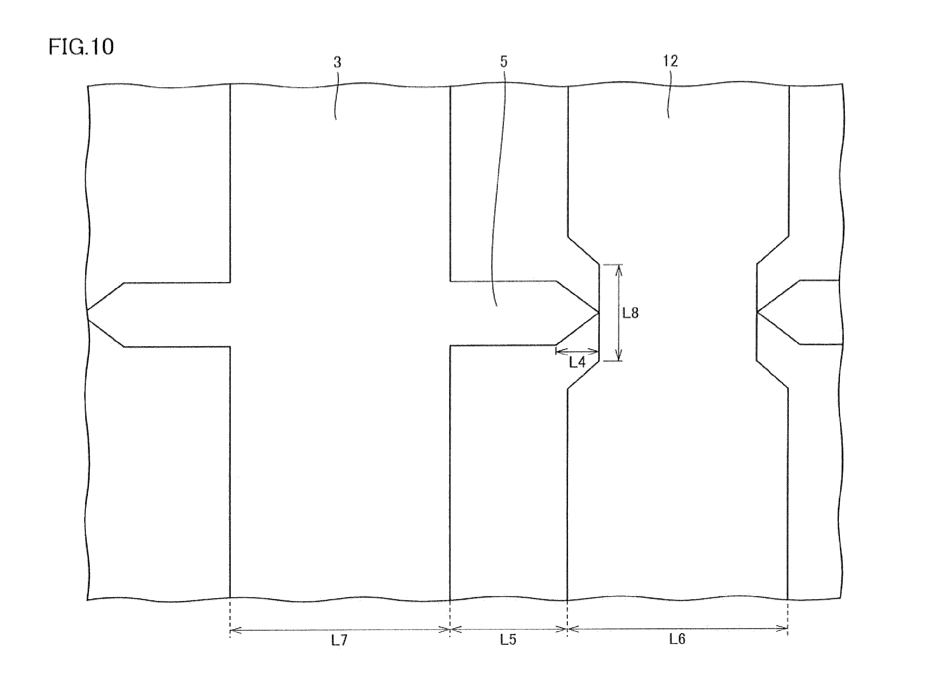

Each of the plurality of contact probes includes contact portion 11, main body portion 12, and tip portion 13 in Fig. 1. As shown in Figs. 9 and 10, a recess may be formed in main body portion 12 on a lateral portion linked to a holding portion 5 of linking member 2.

The plurality of contact probes are each arranged in parallel. In other words, the plurality of contact probes are each aligned in the same direction.

The plurality of contact probes in this step have the shape shown in Fig. 1 on which covering portion 14 has not been formed. It is noted that the contact probe above is not limited in shape and may have any shape depending on use. Further, the plurality of contact probes may have the same shape or may have different shapes. Furthermore, it is only necessary that there are a plurality of the contact probes included in linked body of contact probes 1a, and the number of the contact probes is not particularly limited.

As shown in Fig. 7, linking member 2 links the plurality of contact probes together in areas in the plurality of contact probes other than contact portion 11 and tip portion 13. Linking member 2 includes separating portions 3, a connecting portion 4, holding portions 5, and a grip portion 6. Separating portions 3, connecting portion 4, holding portions 5, and grip portion 6 are linked to each other and in one piece.

There are a plurality of separating portions 3 arranged spaced from each other in parallel (parallel to the vertical direction in Fig. 7). Each contact probe is arranged between the corresponding separating portions of the plurality of separating portions 3. In other words, the plurality of separating portions 3 are arranged between the plurality of contact probes and extend along a direction along which the plurality of contact probes extend. In still other words, separating portion 3 and the contact probe are arranged in alternation and generally in parallel.

Connecting portion 4 links one end of each of the plurality of separating portions 3 (the upper ends in Fig. 1) together. Connecting portion 4 is arranged spaced from contact portions 11 or tip portions 13 (in the present embodiment, contact portions 11) of the plurality of contact probes opposed thereto. That is, contact portions 11 and tip portions 13 of the plurality of contact probes and connecting portion 4 are not in contact with each other. A direction along which connecting portion 4 extends (the lateral direction in Fig. 7) intersects with (in the present embodiment, is orthogonal to) a direction along which separating portion 3 extends (the vertical direction in Fig. 7).

Separating portion 3 and connecting portion 4 are in a comb-like shape when viewed two-dimensionally. In other words, the plurality of separating portions 3 and connecting portion 4 form a comb-like frame portion for the plurality of contact probes when viewed two-dimensionally.

Holding portion 5 is linked to a lateral face of separating portion 3. From opposing lateral faces of separating portion 3, respective holding portions 5 protrude in a direction (the lateral direction in Fig. 7) intersecting with (in the present embodiment, orthogonal to) a direction along which separating portion 3 extends (the vertical direction in Fig. 7), toward adjacent separating portions 3.

Holding portions 5 hold at least two points of the outer circumference of each of the plurality of contact probes along one direction (the lateral direction in Fig. 7) intersecting with (in the present embodiment, orthogonal to) a direction along which the plurality of contact probes extend (the vertical direction in Fig. 7). In other words, holding portions 5 are linked to opposing lateral faces of each of the plurality of contact probes in a region other than contact portion 11 and tip portion 13. Holding portions 5 are aligned along one direction (the lateral direction in Fig. 7) intersecting with a direction along which the plurality of contact probes extend (the vertical direction in Fig. 7).

As shown in Figs. 9 and 10, a tip portion of holding portion 5 may be formed in a tapered manner. Further, a tip of holding portion 5 may have a width L1 as shown in Fig. 9 or may be pointed as shown in Fig. 10.

Although holding portions 5 of the present embodiment each hold a respective one of two opposing points of each of the plurality of contact probes, they may hold one point of each contact probe, or may hold three or more points of each contact probe.

Grip portion 6 is liked to a side of connecting portion 4 opposite the side on which separating portions 3 are formed. Grip portion 6 is, for example, a member for gripping linked body of contact probes 1 a.

Now, an example of the size of linked body of contact probes 1a will be given. As shown in Fig. 9, the tip of holding portion 5 has width L1 of, for example, 10 µm to 20 µm. The plurality of contact probes each have a concave portion in which holding portion 5 is linked. The concave portion has one region and the other region in which holding portion 5 is not linked and which have respective lengths L2 and L3 of, for example, 10 µm to 20 µm. The tapered area of the tip of holding portion 5 has a length L4 of, for example, 10 µm. Holding portion 5 excluding the tip has a length L5 of, for example, 50 µm to 100 µm. Main body portion 12 of the contact probe has a width L6 of, for example, 30 µm to 70 µm. Separating portion 3 has a width L7 of, for example, 50 µm to 100 µm. In the case shown in Fig. 10 where holding portion 5 has a pointed tip, the concave portion of the contact probe has a length L8, which is, for example, the sum of L1, L2, and L3 in Fig. 9.

One hundred contact probes are arranged in parallel, for example, while one hundred and one separating portions 3 are arranged in parallel, for example.

It is noted that although, in the present embodiment, a recess is formed in main body portion 12 of the contact probe to be linked with linking member 2, the contact probe may have a shape without any recess (step). In a case where the recess is formed, even if burrs are produced on a fracture surface between the contact probe and holding portion 5, their protrusion out of the contact probe can be effectively suppressed. In a case where the recess is not formed, burrs can be suppressed by separating the contact probe and linking member 2 from each other with a laser or the like.

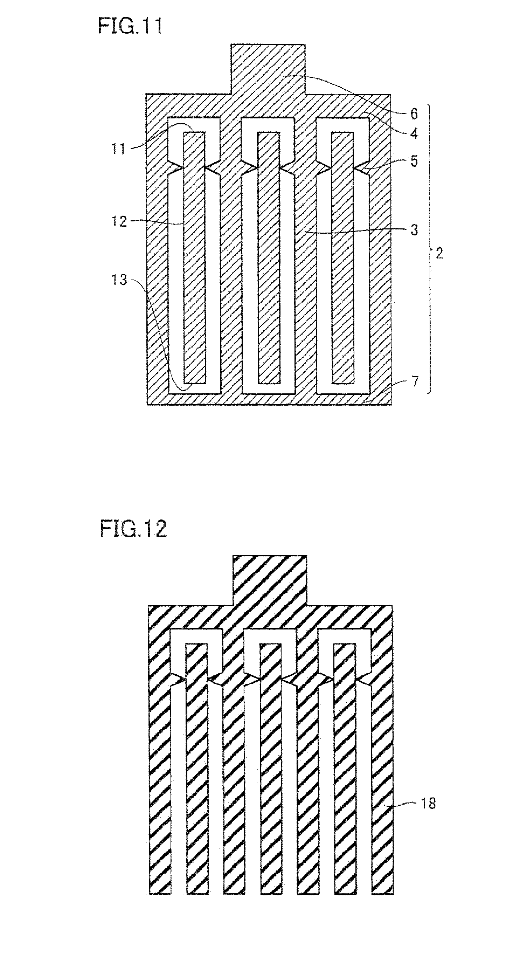

Further, the linked body of contact probes formed in this step may have linking member 2 further including a connecting portion 7 as shown in Fig. 11. Connecting portion 7 links the other ends of a plurality of separating portions 3 (the lower ends in Fig. 7) together and is arranged spaced from contact portions 11 or tip portions 13 (in the present embodiment, tip portions 13) of the plurality of contact probes opposed thereto.

Connecting portion 7 is formed in parallel with connecting portion 4. In other words, a direction (the lateral direction in Fig. 11) along which connecting portion 7 extends intersects with (in the present embodiment, is orthogonal to) a direction along which separating portion 3 extends (the vertical direction in Fig. 11).

When the linked body of contact probes including connecting portion 7 is to be formed, in the step of forming mold 22, opening 22a is formed such that linking member 2 links the other ends of the plurality of separating portions 3 together and further includes connecting portion 7 arranged spaced from contact portions 11 or tip portions 13 of the plurality of contact probes opposed thereto. That is, resin mold 22 which has opening 22a open for linked body of contact probes shown in Fig. 11 is formed.

When connecting portions 4, 7 and separating portion 3 enclose the plurality of contact probes in this manner, a greater strength of the linked body of contact probes can be achieved.

Next, covering portion 14 having a lower volume resistivity than the volume resistivity of main body portion 12 is formed. The step of forming covering portion 14 of the present embodiment includes, as shown in Figs. 12 to 18, the steps of, covering main body portion 12 with an insulating layer 18, exposing main body portion 12 by removing a region where covering portion 14 is formed in insulating layer 18, and forming covering portion 14 on exposed main body portion 12. Specifically, the steps are performed as follows, for example.

Specifically, first, as shown in Fig. 12, insulating layer 18 is formed over the entire surface of linked body of contact probes 1a. For insulating layer 18, for example, an organic film such as a parylene resin can be used, and an organic material having a thin film thickness is suitably used.

A method of forming insulating layer 18 is not particularly limited, and for example, a coating method employing a CVD (Chemical Vapor Deposition) method can be used.

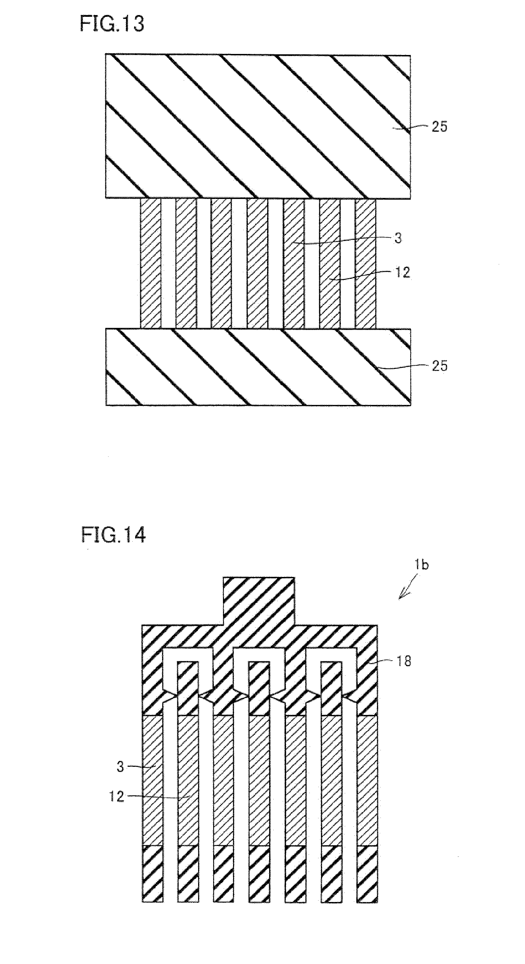

Subsequently, as shown in Fig. 13, a mask layer 25 is formed over insulating layer 18 in a region other than a region where covering portion 14 in Fig. 1 is to be formed. That is, mask layer 25 is open only for a region where covering portion 14 is to be formed. Insulating layer 18 in the present embodiment covers in a manner to be partly open for the middle of linked body of contact probes 1 a. That is, insulating layer 18 is formed in a manner to cover contact portions 11 and tip portions 13 of the plurality of contact probes.

For a region exposed out of mask layer 25, RIE (Reactive Ion Etching) or ashing using, for example, a mixed gas of carbon tetrafluoride (CF₄) and oxygen (O₂) follows. As a result, insulating layer 18 in the region exposed out of mask layer 25 can be removed to expose the metal material that constitutes main body portion 12.

It is noted that instead of mask layer 25, a metal mask may be used. In this case, the metal mask is placed in a manner to cover a region where insulating layer 18 is to be formed.

Subsequently, mask layer 25 is removed. As a result, a linked body of contact probes 1b shown in Fig. 14 can be formed.

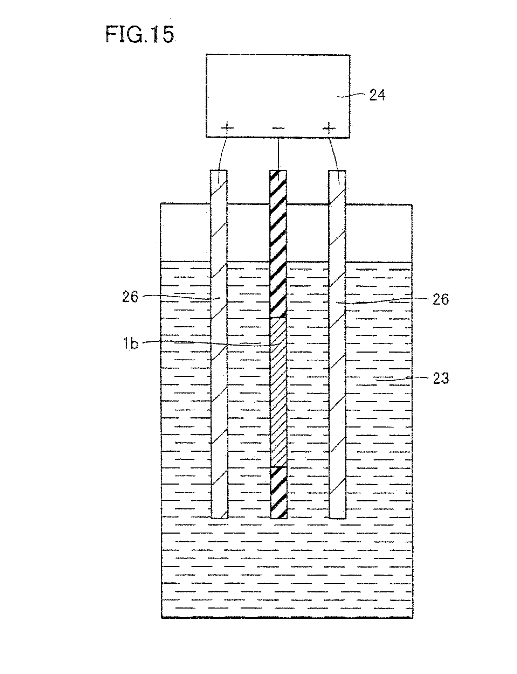

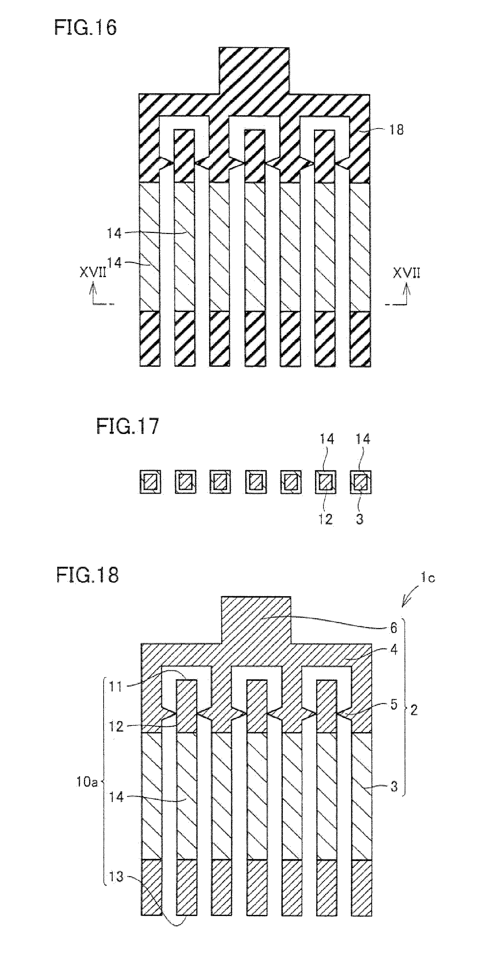

Main body portion 12 which is open in insulating layer 18 of this linked body of contact probes 1b is plated. In the present embodiment, as shown in Fig. 15, a plating solution 23 containing a metal to form covering portion 14 (a metal having a lower volume resistivity than that of main body portion 12), and electrodes 26 are prepared. Linked body of contact probes 1b shown in Fig. 14 is then immersed in plating solution 23. A plating interconnect is drawn from part of linking member 2 of linked body of contact probes 1b (for example, grip portion 6), and linked body of contact probes 1b and electrodes 26 are connected to a power supply 24. At this time, positive poles are arranged on the front and the back of linked body of contact probes 1b, respectively, and a negative pole is arranged at linked body of contact probes 1b. In this case, variations in plating thickness can be suppressed. As a result, as shown in Figs. 16 and 17, the whole outer circumference of main body portion 12 exposed from insulating layer 18 can be covered with covering portion 14.

Next, insulating layer 18 is removed. A method for the removal of insulating layer 18 is not particularly limited, and the above-described RIE or ashing or the like can be used. As a result, as shown in Fig. 18, covering portion 14 having a volume resistivity lower than the volume resistivity of the main body portion 12 can be formed in a manner to cover the whole outer circumference of a cross section of main body portion 12 in a direction (the vertical direction in Fig. 18) intersecting with (in the present embodiment, orthogonal to) an extensional direction, excluding contact portion 11.

A linked body of contact probes 1c shown in Fig. 18 includes a plurality of contact probes 10a of the present embodiment shown in Fig. 1 and linking member 2 linking the plurality of contact probes 10a together in areas in the plurality of contact probes 10a other than contact portion 11 and tip portion 13.

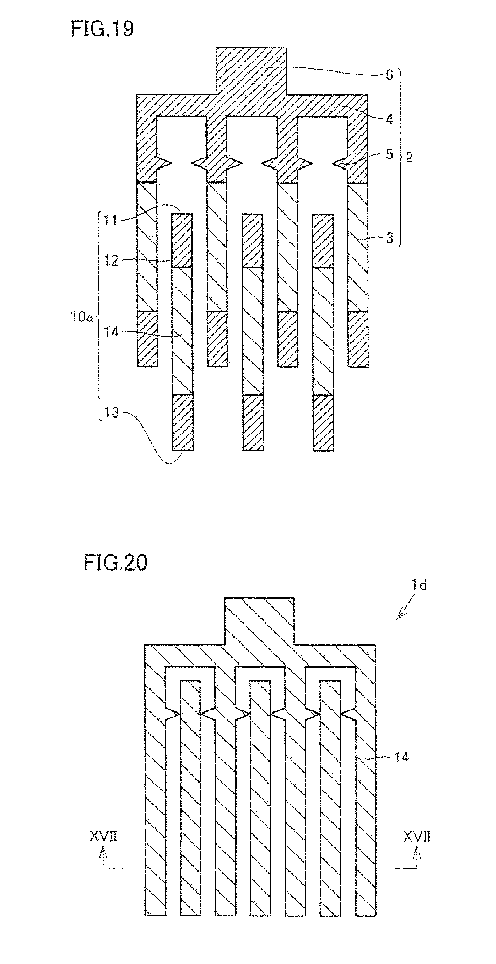

Next, contact probe 10a is separated from linking member 2 in linked body of contact probes 1c as shown in Fig. 19.

Although a method for the separation is not particularly limited, for example, the plurality of contact probes 10a and the plurality of holding portions 5 may be disconnected by arranging linked body of contact probes 1c on an elastic member such as rubber and then pushing the centers of main body portions 12 of the plurality of contact probes. Alternatively, contact points between the plurality of contact probes 10a and the plurality of holding portions 5 may be disconnected with a cutting member such as a cutter. Alternatively, contact probe 10a may be separated from linked body of contact probes 1 c by picking up tip portion 13 of contact probe 10a with a gripping member such as tweezers and then pulling it upward. Alternatively, contact probe 10a and holding portion 5 may be disconnected by irradiating a contact point between contact probe 10a and holding portion 5 with a laser.

It is noted that when contact probe 10a is separated from linking member 2, no metal layer is formed only in an area 9 of contact probe 10a which was in contact with holding portion 5 in Fig. 18. In the present embodiment, a metal layer constituting main body portion 12 is formed in all regions except area 9 which was in contact with holding portion 5. That is, 99 % or more of the surface area of contact probe 10a is covered with the metal layer.

A plurality of contact probes 10a shown in Fig. 1 can be manufactured by carrying out the steps above. A method of manufacturing contact probe 10a in the present embodiment manufactures linked body of contact probes 1a (see Fig. 7), in which a plurality of contact probes 10a on which covering portion 14 has not been formed are linked together. Manufactured from this linked body of contact probes 1a is linked body of contact probes 1b (see Fig. 14), in which main body portion 12 is exposed only in a region where covering portion 14 is to be formed. By using this linked body of contact probes 1b to plate the region where main body portion 12 is exposed with covering portion 14, covering portion 14 which covers the whole circumference of main body portion 12 in a cross sectional direction can be formed. As a result, linked body of contact probes 1c (see Fig. 18) which includes covering portion 14 covering the whole outer circumference of at least part of main body portion 12 in a cross section can be manufactured. By separating contact probes 10a from this linked body of contact probes 1 c, a plurality of contact probes 10a can be manufactured. This step of separating provides easy handling. Further, the plurality of contact probes 10a can be readily separated. Therefore, the manufacturing costs of contact probe 10a can be reduced.

Contact probe 10a manufactured in this manner allows covering portion 14 to cover the whole outer circumference of main body portion 12 in a cross section except at contact portion 11. As a result, even if stress is applied to contact probe 10a, delamination between main body portion 12 and covering portion 14 can be suppressed. Further, since covering portion 14 has a lower volume resistivity than that of main body portion 12, heat generation by contact probe 10a can be suppressed. Therefore, contact probe 10a of the present embodiment allows for stable use. Further, an increased allowable current value of contact probe 10a can also be achieved.

### Second Embodiment

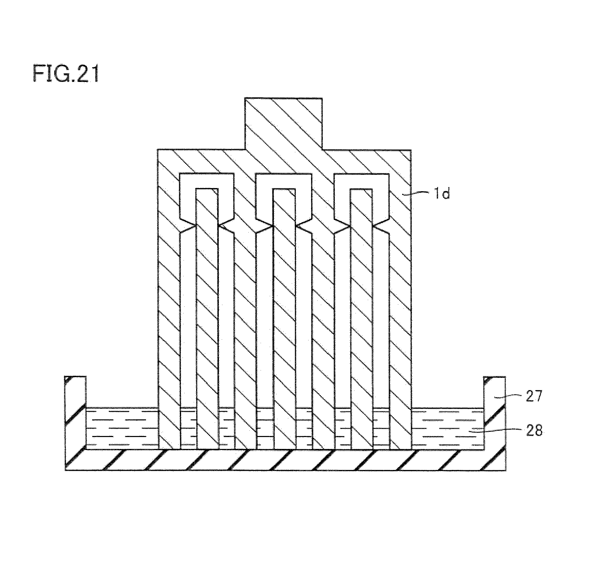

The contact probe in a second embodiment of the present invention has the same shape as that of contact probe 10a shown in Fig. 1 but differs in a manufacturing method. The method of manufacturing contact probe 10a in the present embodiment will be hereinafter described with reference to Figs. 3 to 8 and Figs. 18 to 21. It is noted that Fig. 20 and Fig. 21 are a plan view and a cross sectional view schematically showing each step of the method of manufacturing the contact probe in the present embodiment, respectively.

First, as shown in Figs. 3 and 4, resin mold 22 having opening 22a is formed on substrate 21. Next, as shown in Figs. 5 and 6, opening 22a of mold 22 is filled with a metal material by electroforming. Next, as shown in Figs. 7 and 8, by removing mold 22 and substrate 21, contact portion 11, main body portion 12, and tip portion 13 are formed. These steps are the same as those in the first embodiment, and therefore, the description thereof will not be repeated.

Next, as shown in Fig. 20, a metal layer is formed by covering main body portion 12 with a material to form covering portion 14. In the present embodiment, the metal layer to serve as covering portion 14 is formed on the surface of linked body of contact probes 1a shown in Fig. 7, except grip portion 6. A method of forming this metal layer is not particularly limited, and for example, formed by plating. In this case, for example, instead of linked body of contact probes 1b, a linked body of contact probes 1d shown in Fig. 20 is immersed in plating solution 23, as shown in Fig. 15.

Next, a region in the metal layer other than the region to serve as covering portion 14 is removed. That is, in this step, the metal layer covering contact portion 11 is removed. In the present embodiment, the metal layer covering contact portion 11 and tip portion 13 is removed.

A method for the removal is not particularly limited, and for example, machining, etching, or the like can be employed. As to machining, for example, the metal layer is removed by polishing. For etching, although either dry etching or wet etching can be used, preferably, etching is performed through wet etching.

When the removal is made by wet etching, for example, as shown in Fig. 21, an etchant 28 is contained in a container 27 and a region to be removed in the metal layer is immersed in etchant 28. For etchant 28, for example, copper chloride, ferric chloride, or the like can be used in the case where covering portion 14 is, for example, copper. As a result, linked body of contact probes 1c shown in Fig. 18 can be manufactured.

Next, as shown in Fig. 19, contact probe 10a is separated from linking member 2 in linked body of contact probes 1c. This step is the same as that in the first embodiment, and therefore, the description thereof will not be repeated. Contact probe 10a shown in Figs. 1 and 2 can be manufactured by carrying out the steps above.

### Third Embodiment

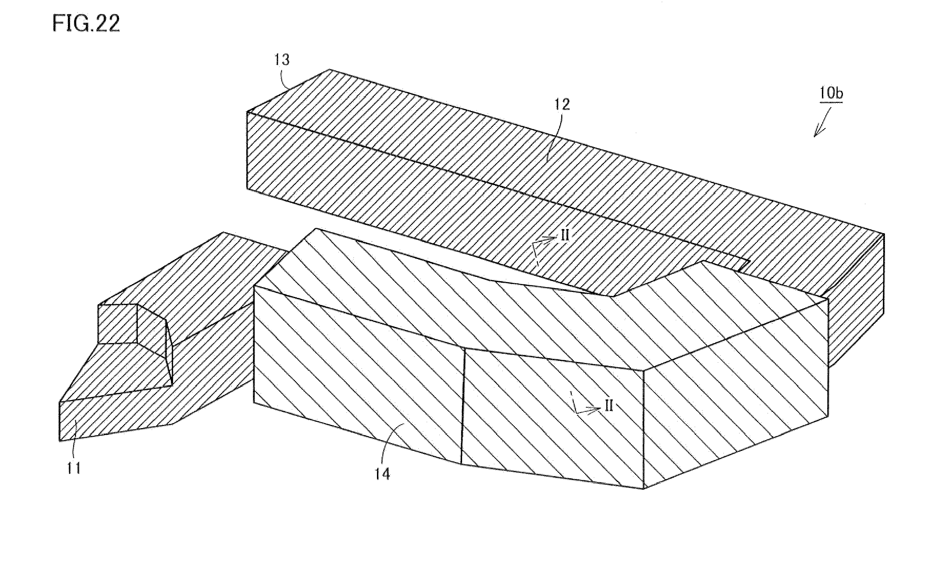

Referring to Figs. 2 and 22, a contact probe 10b in the present embodiment will be described. It is noted that a cross section along a line II-II in Fig. 22 is as shown in Fig. 2.

As shown in Fig. 22, contact probe 10b in the present embodiment basically has the same configuration as that of contact probe 10a of the first embodiment shown in Fig, 1, but differs in that main body portion 12 includes a spring portion which elastically deforms at the time of contacting a measured surface of an electrical, and a supporting portion which is connected to the spring portion for supporting the spring portion and that stopper 15 is eliminated. That is, main body portion 12 of the present embodiment has a curved shape. It is noted that, in the present embodiment, the spring portion is connected to contact portion 11, and the supporting portion is connected to tip portion 13.

Contact probe 10b of the present embodiment also includes covering portion 14 which covers the whole circumference of a cross section of main body portion 12 in a direction intersecting with an extensional direction, excluding contact portion 11, and has a lower volume resistivity than the volume resistivity of the main body portion. In the present embodiment, the spring portion of main body portion 12 is covered with covering portion 14. An area covered with covering portion 14 has a cross-sectional shape in which the whole circumference of main body portion 12 is covered with covering portion 14, as shown in Fig. 2.

It is noted that an extensional direction of main body portion 12 in the present embodiment refers to an extensional direction at each position. That is, the direction along which main body portion 12 extends in the present embodiment differs at each of the positions.

A method of manufacturing contact probe 10b in the present embodiment is basically the same as the method of manufacturing contact probe 10a of the first embodiment, but differs in that in the step of forming mold 22, region R1 in opening 22a to form a contact probe has a shape of a contact probe having contact portion 11, main body portion 12, and tip portion 13 which are shown in Fig. 22 (the shape in Fig. 22 on which covering portion 14 has not been formed).

It is noted that the contact probe of the present invention is not particularly limited to the shapes shown in Figs. 1 and 22 and applicable to other shapes.

### Fourth Embodiment

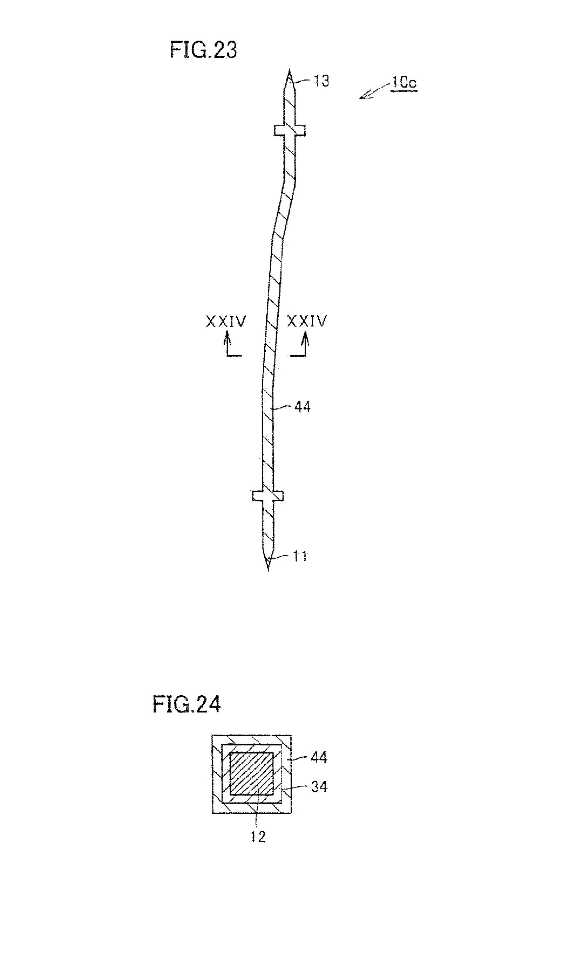

Referring to Figs. 23 and 24, a contact probe 10c in the present embodiment will be described.

Although contact probe 10c shown in Figs. 23 and 24 basically has the same configuration as that of contact probe 10a shown in Fig. 1, it is entirely covered with a covering portion from tip portion 13 to contact portion 11. The covering portion is made of a first covering layer 34 covering the entire main body portion 12, as shown in Fig. 24. A second covering layer 44 covering the whole outer circumference of this first covering layer 34 is arranged. It is noted that the covering portion may have a configuration of a multilayer structure including two or more layers.

For the material of first covering layer 34, any conductive material can be used, and, for example, copper (Cu) or a copper alloy can be used. The lower limit of the thickness of first covering layer 34 can be, for example, 1 µm, more preferably, 1.5 µm, and further preferably, 2 µm. The upper limit of the thickness of first covering layer 34 can be, for example, not more than 5 µm, more preferably, 4 µm, and further preferably, 3 µm.

For the material of second covering layer 44, although any conductive material can be used, preferably, a material having oxidation resistance is used. For instance, as the material of second covering layer 44, gold (Au), platinum (Pt), palladium (Pd), ruthenium (Ru), iridium (Ir), nickel (Ni), rhodium (Rh), or the like can be used. It is particularly preferable to use rhodium as second covering layer 44. The lower limit of the thickness of second covering layer 44 can be, for example, 0.1 µm, more preferably, 0.2 µm, and further preferably, 0.5 µm. The upper limit of the thickness of second covering layer 44 can be 3 µm, preferably, 2 µm, and more preferably, 1 µm.

Herein, the thicknesses of first covering layer 34 and second covering layer 44 as described above can be determined by a method as follows, for example. That is, as to the first covering layer, there is a case where it is desired to obtain a large current value under a constant voltage when a probe is in use. In this case, resistance serves as an important factor to determine the upper value of the current. Resistance is made up of "conductor resistance" of the probe and "contact resistance" of an object to be inspected. Assuming that "conductor resistance" is dominant, the conductor resistance can be considered as combined resistance R3 of resistance R1 of a base material (main body portion 12) and resistance R2 of a covering layer (for example, first covering layer 34). It is noted that R3 can be determined by an expression (1/R3) = (1/R1) + (1/R2). Then, a method such as designing the thickness of the covering layer so that R2 satisfies necessary R3 can be used. As to second covering layer 44, the determination can be made as follows. That is, probes having second covering layers 44 with various thicknesses are fabricated, and subjected to an accelerated test under usage environment conditions (temperature and humidity conditions similar to those in the usage environment). Subsequently, an analysis is made by XPS (X-ray Photoelectron Spectroscopy) from the surface of the probe in the depth direction, thereby confirming whether or not oxidation of first covering layer 34 has occurred. This enables a necessary thickness of second covering layer 44 to be experimentally determined.

For the material of main body portion 12, for example, a nickel-tungsten alloy (Ni-W alloy) can be used.

Such a configuration can cover the entire contact probe 10c with first covering layer 34 and second covering layer 44, thereby suppressing heat generation by contact probe 10c and providing improved durability.

### Fifth Embodiment: Linked Body of Contact Probes

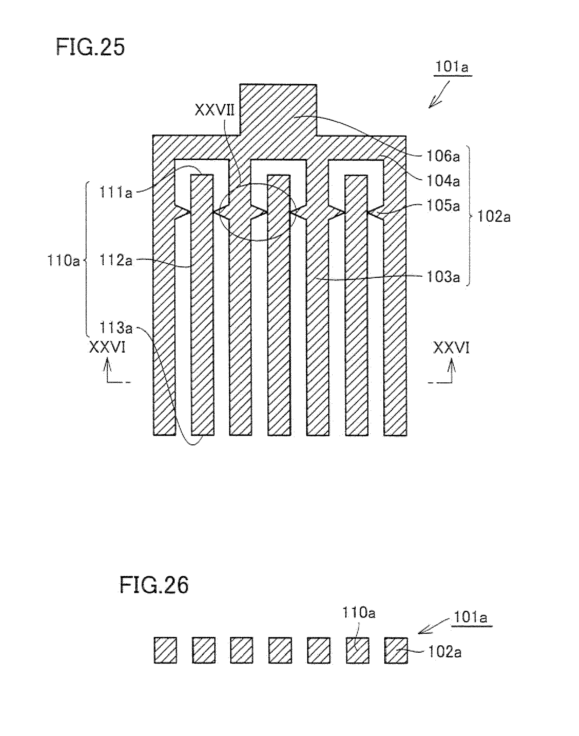

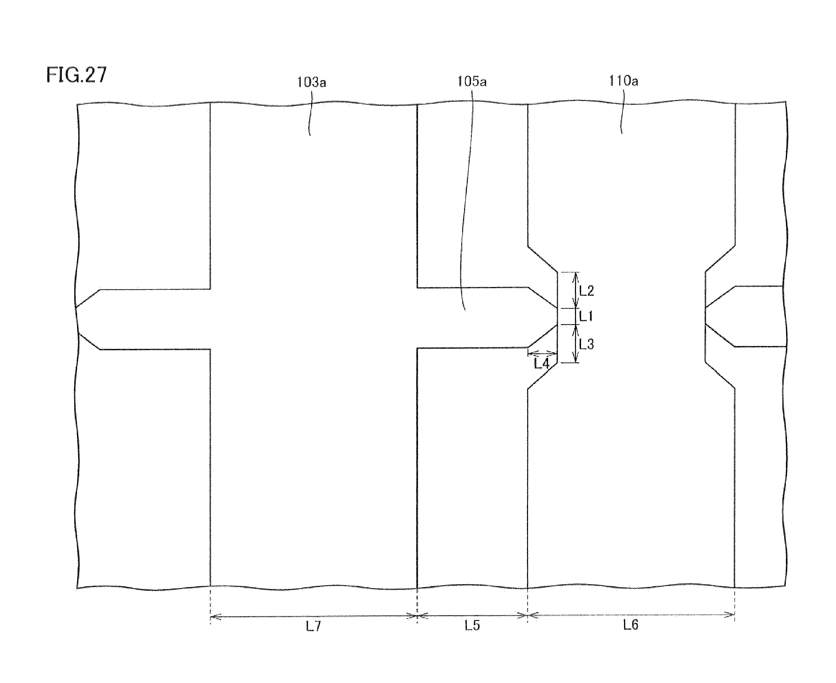

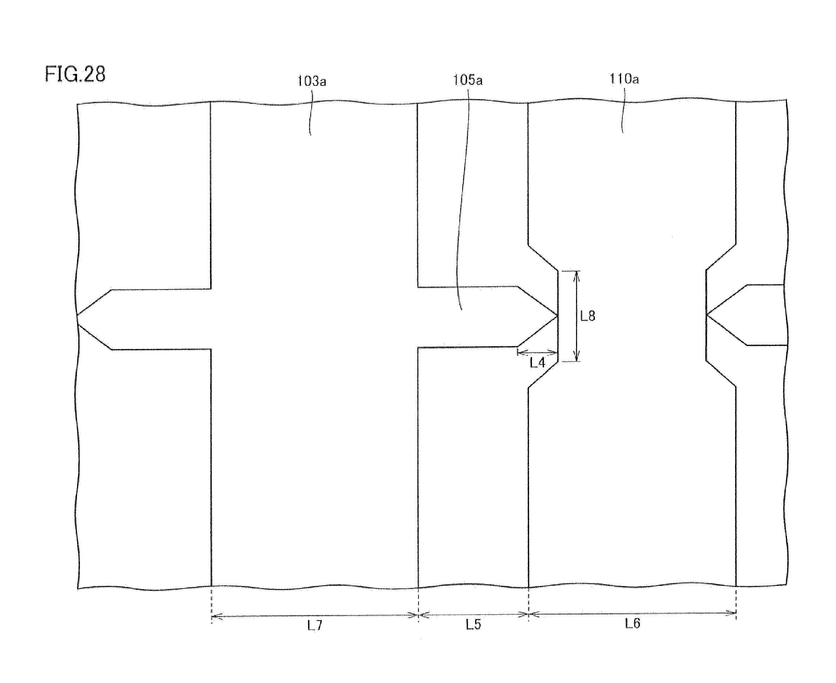

Fig. 25 is a plan view schematically showing a linked body of contact probes 101a in a fifth embodiment of the present invention. Fig. 26 is a cross sectional view along a line XXVI-XXVI in Fig. 25. Fig. 27 is an enlarged view of a region XXVII in Fig. 25. Fig. 28 is another enlarged view of region XXVII in Fig. 25. Referring to Figs. 25 and 26, linked body of contact probes 101a in the present embodiment will be described.

As shown in Figs. 25 and 26, linked body of contact probes 101a includes a plurality of contact probes 110a and a linking member 102a. The plurality of contact probes 110a and linking member 102a are linked together and in one piece. That is, the plurality of contact probes 110a are interlinked through linking member 102a.

Contact probe 110a is pushed onto an object to be measured such as a measured surface of an electrical circuit to measure various electrical properties. Each of the plurality of contact probes 110a includes a contact portion 111a to be brought into contact with an object to be measured, a main body portion 112a linked to contact portion 111a, and a tip portion 113a linked to main body portion 112a and opposite contact portion 111a. As shown in Figs. 27 and 28, a recess may be formed in main body portion 112a on a lateral portion linked to a holding portion 105a of linking member 102a.

The plurality of contact probes 110a are each arranged in parallel. In other words, the plurality of contact probes 110a are each aligned in the same direction.

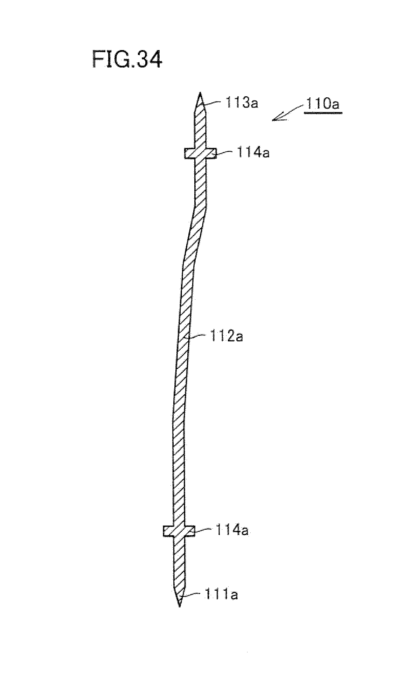

The plurality of contact probes 110a have, for example, a shape shown in Fig. 34. It is noted that the contact probe above is not limited in shape and may have any shape depending on use. Further, the plurality of contact probes may have the same shape or may have different shapes. Furthermore, it is only necessary that there are a plurality of contact probe 11 0a included in linked body of contact probes 101a, and the number of the contact probes is not particularly limited.

Linking member 102a links the plurality of contact probes 110a together in areas in the plurality of contact probes 110a other than contact portion 111a and tip portion 113a. Linking member 102a includes separating portions 103a, a connecting portion 104a to serve as a first connecting portion, holding portions 105a, and a grip portion 106a. Separating portions 103a, connecting portion 104a, holding portions 105a, and grip portion 106a are linked to each other and in one piece.

There are a plurality of separating portions 103a arranged spaced from each other in parallel (parallel to the vertical direction in Fig. 25). Each contact probe 110a is arranged between the corresponding separating portions of the plurality of separating portions 103a. In other words, the plurality of separating portions 103a are arranged between the plurality of contact probes 110a and extend along a direction along which the plurality of contact probes 110a extend. In still other words, separating portions 103a and contact probes 110a are arranged in alternation and generally in parallel.

Connecting portion 104a links one end of each of the plurality of separating portions 103a (the upper ends in Fig. 25) together. Connecting portion 104a is arranged spaced from contact portions 111a or tip portions 113a (in the present embodiment, contact portions 111a) of the plurality of contact probes 110a opposed thereto. That is, contact portions 111a and tip portions 113a of the plurality of contact probes 110a and connecting portion 104a are not in contact with each other. A direction along which connecting portion 104a extends (the lateral direction in Fig. 25) intersects with (in the present embodiment, is orthogonal to) a direction along which separating portion 103a extends (the vertical direction in Fig. 25).

Separating portion 103a and connecting portion 104a are in a comb-like shape when viewed two-dimensionally. In other words, the plurality of separating portions 103a and connecting portion 104a form a comb-like frame portion for the plurality of contact probes 110a when viewed two-dimensionally.

Holding portion 105a is linked to a lateral face of separating portion 103a. From opposing lateral faces of separating portion 103a, respective holding portions 105a protrude in a direction (the lateral direction in Fig. 25) intersecting with (in the present embodiment, orthogonal to) a direction along which separating portion 103a extends (the vertical direction in Fig. 25), toward adjacent separating portions 103a.

Holding portions 105a hold at least two points of the outer circumference of each of the plurality of contact probes 110a along one direction (the lateral direction in Fig. 25) intersecting with (in the present embodiment, orthogonal to) a direction along which the plurality of contact probes 110a extend (the vertical direction in Fig. 25). In other words, holding portions 105a are linked to opposing lateral faces of each of the plurality of contact probes 110a in a region other than contact portion 111a and tip portion 113a. Holding portions 105a are aligned along one direction (the lateral direction in Fig. 25) intersecting with a direction along which the plurality of contact probes 110a extend (the vertical direction in Fig. 25).

As shown in Figs. 27 and 28, a tip portion of holding portion 105a may be formed in a tapered manner. Further, a tip of holding portion 105a may have a width L1 as shown in Fig. 27 or may be pointed as shown in Fig. 28.

Although holding portions 105a of the present embodiment each hold a respective one of two opposing points of each of the plurality of contact probes 110a, they may hold one point of each contact probe 110a, or may hold three or more points of each contact probe 110a.

Grip portion 106a is linked to a side of connecting portion 104a opposite the side on which separating portions 103a are formed. Grip portion 106a is, for example, a member for gripping linked body of contact probes 101a.

Linked body of contact probes 101a is formed of the same material in one piece. Examples of such a material include Ni (nickel), an alloy of Ni and Mn (manganese), an alloy of Ni and W (tungsten), an alloy of Ni and Fe (iron), an alloy of Ni and Co (cobalt), and the like.

Now, an example of the size of linked body of contact probes 101a will be given. As shown in Fig. 27, the tip of holding portion 105a has a width L1 of, for example, 10 µm to 20 µm. The plurality of contact probes 110a each have a concave portion in which holding portion 105a is linked. The concave portion has one region and the other region in which holding portion 105a is not linked and which have respective lengths L2 and L3 of, for example, 10 µm to 20 µm. The tapered area of the tip of holding portion 105a has a length L4 of, for example, 10 µm. Holding portion 105a excluding the tip has a length L5 of, for example, 50 µm to 100 µm. Contact probe 110a has a width L6 of, for example, 30 µm to 70 µm, separating portion 103a has a width L7 of, for example, 50 µm to 100 µm. In the case shown in Fig. 28 where holding portion 105a has a pointed tip, the concave portion of contact probe 110a has a length L8, which is, for example, the sum of L1, L2, and L3 in Fig. 27.

One hundred contact probes 110a are arranged in parallel, for example, while one hundred and one separating portion 103 a are arranged in parallel, for example.

It is noted that although, in the present embodiment, a recess is formed in main body portion 112a of contact probe 110a to be linked with linking member 102a, the contact probe may have a shape without any recess (step). In a case where the recess is formed, even if burrs are produced on a fracture surface between contact probe 110a and holding portion 105a, their protrusion out of contact probe 110a can be effectively suppressed. In a case where the recess is not formed, burrs can be suppressed by separating contact probe 110a and linking member 102a from each other with a laser or the like.

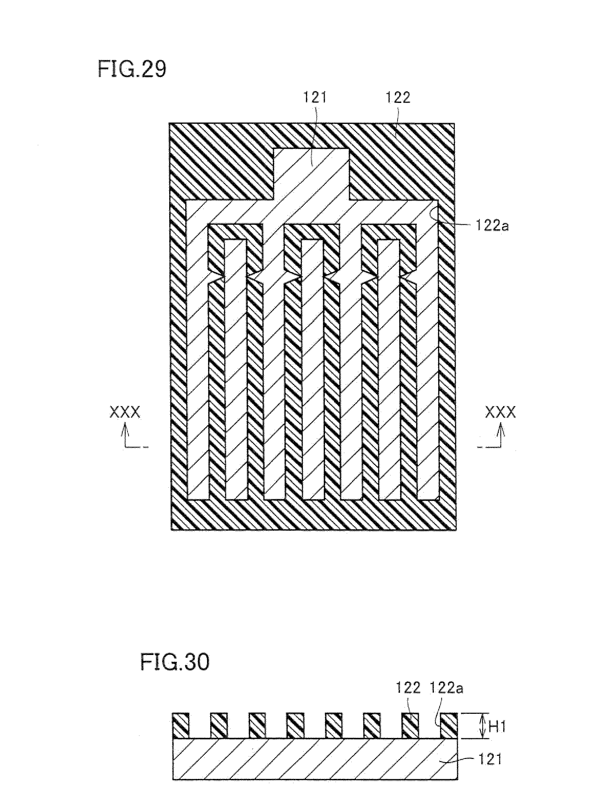

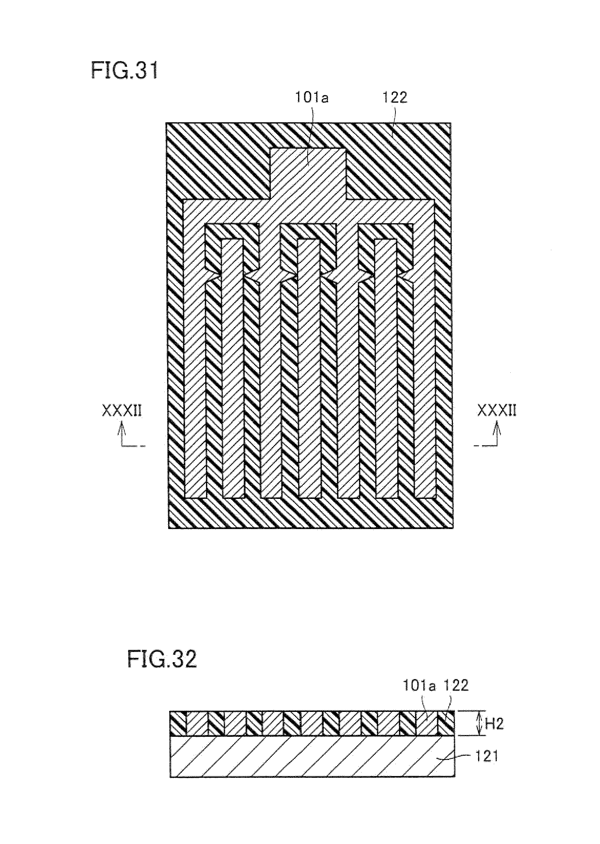

A method of manufacturing linked body of contact probes 101a in the present embodiment will be described in the following with reference to Figs. 25 to 32. It is noted that Fig. 29 is a plan view schematically showing a first step for manufacturing linked body of contact probes 101a in the present embodiment. Fig. 30 is a cross sectional view along a line XXX-XXX in Fig. 29. Fig. 31 is a plan view schematically showing a second step for manufacturing linked body of contact probes 101a in the present embodiment. Fig. 32 is a cross sectional view along a line XXXII-XXXII in Fig. 31.

First, as shown in Figs. 29 and 30, a resin mold 122 having an opening 122a is formed on a substrate 121. In this step of forming mold 122, opening 122a having a shape open for linked body of contact probes 101 a shown in Fig. 25 is formed. That is, opening 122a open for a region to form a plurality of contact probes 110a including contact portion 111a to be brought into contact with an object to be measured and tip portion 113a opposite contact portion 111a and for a region to form linking member 102a linking the plurality of contact probes 110a together in areas in the plurality of contact probes 110a other than contact portion 111a and tip portion 113a is formed.

In this step, linking member 102a can have any specific structure that links the plurality of contact probes 110a, and there only has to be one linked point. Preferably, opening 122a is formed such that linking member 102a includes holding portions 105a holding at least two points of the outer circumference of each of the plurality of contact probes 110a along one direction intersecting with a direction along which the plurality of contact probes 110a extend. Further, opening 122a is formed such that linking member 102a includes a plurality of separating portions 103a arranged spaced from each other in parallel and connecting portion 104a linking one end of each of the plurality of separating portions 103a together; that each of the plurality of contact probes 110a is arranged between corresponding separating portions of the plurality of separating portions 103a; and that contact portion 111a or tip portion 113a opposed to connecting portion 104a is arranged spaced from connecting portion 104a.

Specifically, first, substrate 121 is prepared. Substrate 121 is not particularly limited, and, for example, a metal substrate of copper (Cu), nickel (Ni), stainless steel such as SUS, aluminum (Al) or the like, an Si substrate to which conductivity is imparted, a glass substrate, or the like can be used. On this substrate 121, a resin layer to serve as resin mold 122 is formed. This resin layer is not particularly limited, and, for example, a resist of resin material primarily composed of polymethacrylic acid ester, an ultraviolet ray (UV) sensitive or X-ray sensitive chemical amplification type resin material, or the like can be used. The thickness of the resin layer (a thickness H1 in Fig. 30) can be set to any thickness according to the thickness of linked body of contact probes 101 a to be formed. In the present embodiment, thickness H1 of the resin layer is approximately 10% to 20% thicker than the thickness of contact probe 110a to be formed, and for example, 40 µm.

Subsequently, a mask having an absorbing layer not allowing light to pass through and a light-transmitting layer allowing light to pass through is arranged on the resin layer. The absorbing layer of the mask has the same shape as the shape of linked body of contact probes 101a shown in Fig. 25 if a positive resist is used. If a negative resist is used as the resin layer, the absorbing layer of the mask has a shape which is the inverse of that of linked body of contact probes 101a. Irradiation of light such as UV ray or X ray through the mask follows. The irradiation of light does not expose the resin layer located under the absorbing layer, and causes the resin layer located under the light-transmitting layer to change in quality. As a result, development removes only the area that has changed in quality (molecular chains are cut) if the resin layer is of a positive resin, and resin mold 122 as shown in Figs. 29 and 30 can be provided.

Next, as shown in Figs. 31 and 32, opening 122a of mold 122 is filled with a metal material by electroforming. Specifically, a metal ion solution containing a material to form linked body of contact probes 101a shown in Fig. 25 is prepared. Using this metal ion solution, a layer made of the metal material is formed in opening 122a of mold 122 on substrate 121. For instance, by electroforming using substrate 121 as a plating electrode, the metal material can be deposited in opening 122a of mold 122. At this time, the metal material is deposited to the extent of filling up opening 122a of mold 122.

Next, the surface of the metal material filled in opening 122a of mold 122 is polished or grinded. As a result, the thickness of the metal material (a thickness H2 in Fig. 32) is adjusted to be the same as the thickness of linked body of contact probes 101a to be formed. In the present embodiment, the metal material has thickness H2 of, for example, 30 µm.

Next, mold 122 and substrate 121 are removed. Although a method for the removal is not particularly limited, for example, mold 122 is removed by wet etching, plasma ashing, or the like. Subsequently, substrate 121 is removed by, for example, wet etching with an acid or an alkali, machining, or the like. As a result, linked body of contact probes 101a shown in Figs. 25 and 26 can be manufactured.

As described above, linked body of contact probes 101a and the manufacturing method thereof in the present embodiment can realize linked body of contact probes 101a made into one piece by linking, by means of linking member 102a, the plurality of contact probes 110a together at main body portion 112a which has a small effect on the function of the contact probe. Linked body of contact probes 101a is larger than individual contact probe 110a, and thus easy to handle. Further, subjecting linked body of contact probes 101a to an aftertreatment can provide improved productivity over subjecting individual contact probes 110a to the aftertreatment, and therefore, cost reduction can be achieved.

### Sixth Embodiment: Linked Body of Contact Probes

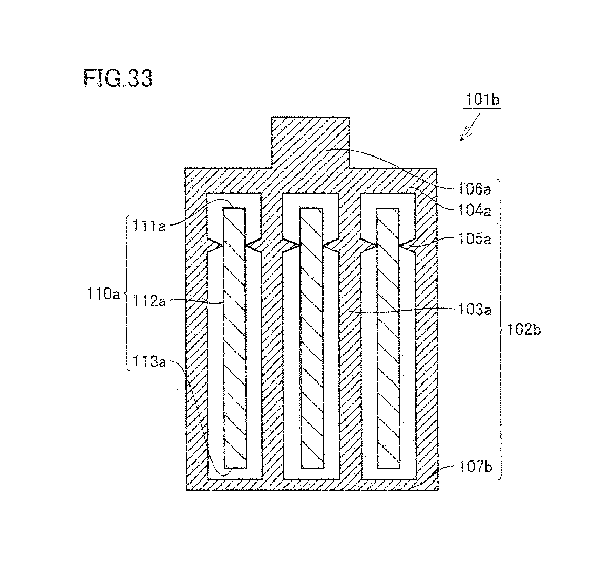

Fig. 33 is a plan view schematically showing a linked body of contact probes 101b in a sixth embodiment of the present invention. Referring to Fig. 33, linked body of contact probes 101b in the present embodiment will be described.

As shown in Fig. 33, linked body of contact probes 101b in the present embodiment basically has the same configuration as that of linked body of contact probes 101 a of the fifth embodiment shown in Fig. 25, but differs in that linked body of contact probes 101b in the present embodiment has a linking member 102b further including a connecting portion 107b to serve as a second connecting portion.

Connecting portion 107b links the other ends of the plurality of separating portions 103a (the lower ends in Fig. 33) together and is arranged spaced from contact portions 111a or tip portions 113a (in the present embodiment, tip portion 113a) of the plurality of contact probes 110a opposed thereto.

Connecting portion 107b is formed in parallel with connecting portion 104a. In other words, a direction (the lateral direction in Fig. 33) along which connecting portion 107b extends intersects with (in the present embodiment, is orthogonal to) a direction along which separating portion 103a extends (the vertical direction in Fig. 33).

A method of manufacturing linked body of contact probes 101b in the present embodiment basically has the same configuration as the method of manufacturing linked body of contact probes 101a of the fifth embodiment, but differs in that in the step of forming mold 122, opening 122a is formed such that linking member 102b links the other ends of the plurality of separating portions 103a together and further includes connecting portion 107b arranged spaced from contact portions 111 a or tip portions 113a of the plurality of contact probes 110a opposed thereto. That is, in the present embodiment, resin mold 122 which has opening 122a open for linked body of contact probes 101b shown in Fig. 33 is formed.

Linked body of contact probes 101b and the manufacturing method thereof in the present embodiment enables connecting portions 104a, 107b and separating portions 103a to enclose the plurality of contact probes 110a. As a result, a greater strength of the linked body of contact probes 101b can be achieved. Therefore, separation can be readily achieved in separating the plurality of contact probes 110a from linked body of contact probes 101b, and easier handling is provided.

### Seventh Embodiment: Contact Probe

Fig. 34 is a plan view schematically showing contact probe 110a in a seventh embodiment of the present invention. Referring to Fig. 34, contact probe 110a in the present embodiment will be described. Contact probe 110a of the present embodiment is fabricated using linked body of contact probes 101a of the fifth embodiment shown in Figs. 25 and 26 or linked body of contact probes 101b of the sixth embodiment shown in Fig. 33.

Contact probe 110a includes contact portion 111a, main body portion 112a, tip portion 113a, and stoppers 114a. Contact portion 111a is brought into contact with an object to be measured. Main body portion 112a is linked to contact portion 111a. Tip portion 113a is linked to main body portion 112a and is an end opposite contact portion 111a. Tip portion 113a is brought into contact with, for example, a connection terminal of an inspection apparatus. Stoppers 114a are protrusions which are linked from the center side of main body portion 112a to the contact portion 111a side and to the tip portion 113a side, respectively, and protrude in a direction which intersects with a direction along which main body portion 112a extends. Stopper 114a is a member for securing contact probe 110a to a jig when the contact probe is pushed onto an object to be measured such as a measured surface of an electrical circuit to measure various electrical properties. That is, stopper 114a supports contact probe 110a to prevent it from moving at the time of measurement.

It is noted that contact probe of the present invention is not particularly limited in shape and applicable to a contact probe having other shapes such as a shape with a curved main body.

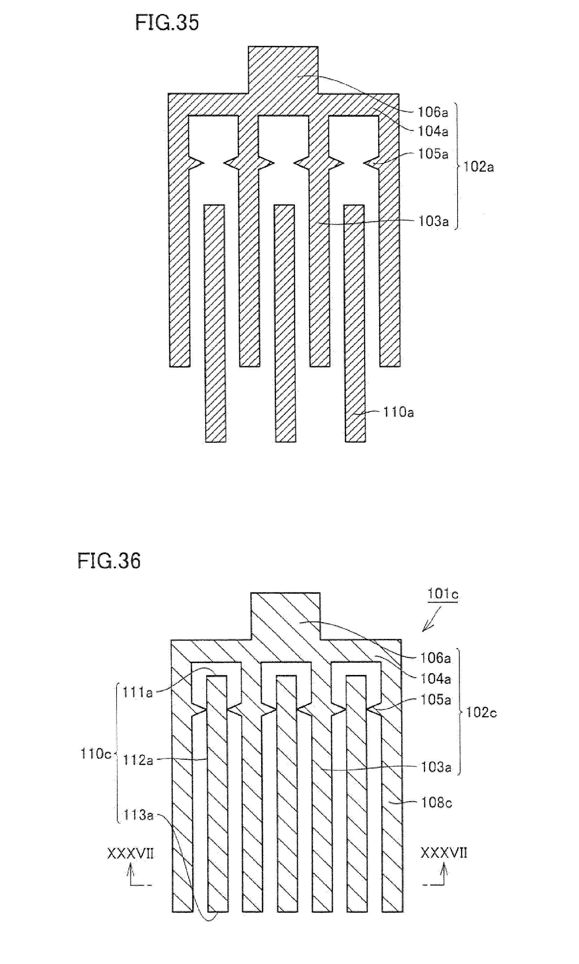

A method of manufacturing contact probe 110a in the present embodiment will be described in the following with reference to Figs. 25 to 35. It is noted that Fig. 35 is a plan view showing a step for manufacturing the contact probe in the present embodiment.

First, linked body of contact probes 101a of the fifth embodiment in Fig. 25 or linked body of contact probes 101b of the sixth embodiment in Fig. 33 is manufactured.

Next, contact probe 110a is separated from linking member 102a, 102b in linked body of contact probes 101a, 101b as shown in Fig. 35.

Although a method for the separation is not particularly limited, for example, the plurality of contact probes 110a and the plurality of holding portions 105a may be disconnected by arranging linked body of contact probes 101a on an elastic member such as rubber and then pushing the centers of main body portions 112a of the plurality of contact probes 110a. Alternatively, contact points between the plurality of contact probes 110a and the plurality of holding portions 105a may be disconnected with a cutting member such as a cutter. Alternatively, the contact probe may be separated from linked body of contact probes 101a, 101b by picking up tip portion 113a of contact probe 110a with a gripping member such as tweezers and then pulling it upward. Alternatively, contact probe 110a and holding portion 105a may be disconnected by irradiating a contact point between contact probe 110a and holding portion 105a with a laser.

A plurality of contact probe 110a shown in Fig. 34 can be manufactured by carrying out the steps above. According to contact probe 110a and the manufacturing method thereof in the present embodiment, a plurality of contact probes 110a can be manufactured by separating a plurality of contact probes from linked body of contact probes 101a, 101b. This step of separating provides easy handling. Further, the plurality of contact probes can be readily separated, and therefore, cost reduction can be achieved.

### Eighth Embodiment: Linked Body of Contact Probes

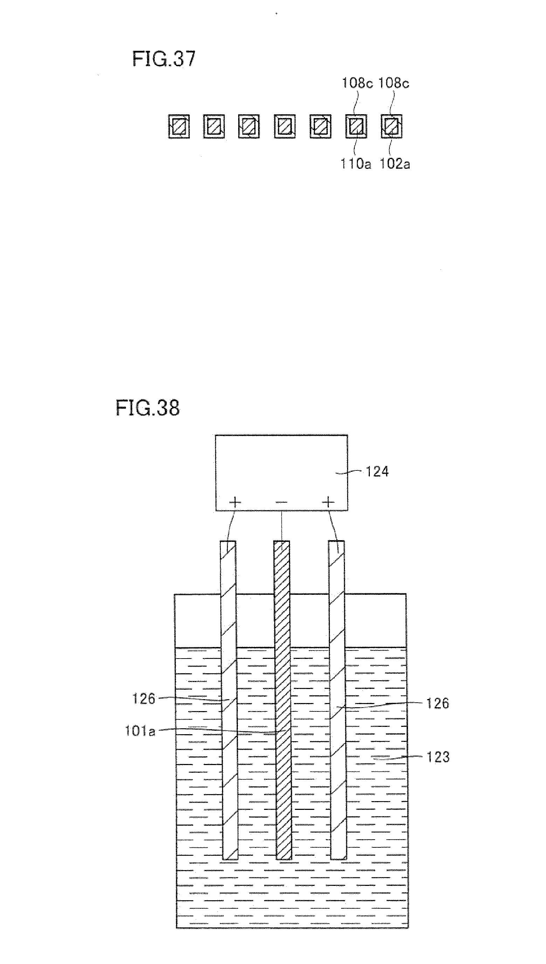

Fig. 36 is a plan view schematically showing a linked body of contact probes 101c in an eighth embodiment of the present invention. Fig. 37 is a cross sectional view along a line XXXVII-XXXVII in Fig. 36. Referring to Figs. 36 and 37, linked body of contact probes 101c in the present embodiment will be described. As shown in Figs. 36 and 37, linked body of contact probes 101c in the present embodiment basically has the same configuration as that of linked body of contact probes 101a in the fifth embodiment shown in Figs. 25 and Fig. 26. Linked body of contact probes 101c in the present embodiment is, however, different in that a metal layer 108c covering the entire surface of linked body of contact probes 101a except grip portion 106a is further formed.

Metal layer 108c of the present embodiment uniformly covers the entire surface of linked body of contact probes 101 a. For metal layer 108c, for example, rhodium (Rh), Au, Cu, PdCo (palladium cobalt) can be used.

A method of manufacturing linked body of contact probes 101c in the present embodiment will be described in the following with reference to Figs. 36 to 38. It is noted that Fig. 38 is a schematic diagram showing the step of plating in the present embodiment. First, linked body of contact probes 101a of the fifth embodiment is manufactured.

Next, as shown in Fig. 38, the entire surface of linked body of contact probes 101a is plated. Specifically, a plating solution 123 containing a metal to form metal layer 108c, and electrodes 126 are prepared. Linked body of contact probes 101a is immersed in plating solution 123. A plating interconnect is drawn from part of linking member 102a of linked body of contact probes 101a (for example, grip portion 106a), and linked body of contact probes 101a and electrodes 126 are connected to a power supply 124. At this time, positive poles are arranged on the front and the back of linked body of contact probes 101 a, and a negative pole is arranged at linked body of contact probes 101a. In this case, variations in plating thickness can be suppressed. As a result, the entire surface of linked body of contact probes 101a can be plated with metal layer 108c.

Linked body of contact probes 101c shown in Figs. 36 and 37 having metal layer 108c formed on the whole outer circumference thereof can be manufactured by carrying out the steps above.

According to linked body of contact probes 101c and the manufacturing method thereof of the present embodiment, metal layer 108c is formed while a plurality of contact probes 110c are in a state of being linked together. Linked body of contact probes 101c of the present embodiment does not require that contact probe 110c be individually gripped, and therefore, metal layer 108c can be readily formed as compared with a case where contact probes are individually plated. Therefore, easy handling can be provided, and cost reduction can be achieved.

Further, formation of metal layer 108c can improve the properties of the plurality of contact probes 110a depending on the selected metal material and thickness. For instance, metal layer 108c formed of Rh can improve abrasion resistance, metal layer 108c formed of Rh or PdCo can reduce contact resistance, and metal layer 108c formed of Cu or Au can improve allowable current value.

Here, in the present embodiment, metal layer 108c is formed after linked body of contact probes 101a of the fifth embodiment is manufactured; however, metal layer 108c may be formed after linked body of contact probes 101b of the sixth embodiment is manufactured. In this case, connecting portions 104a, 107b are linked to separating portion 103a to serve as a frame body for contact probes 110a, and therefore, linked body of contact probes 101b has high stability. As a result, in forming metal layer 108c, a further reduction of variations in plating thickness can be achieved.

### Ninth Embodiment: Contact Probe

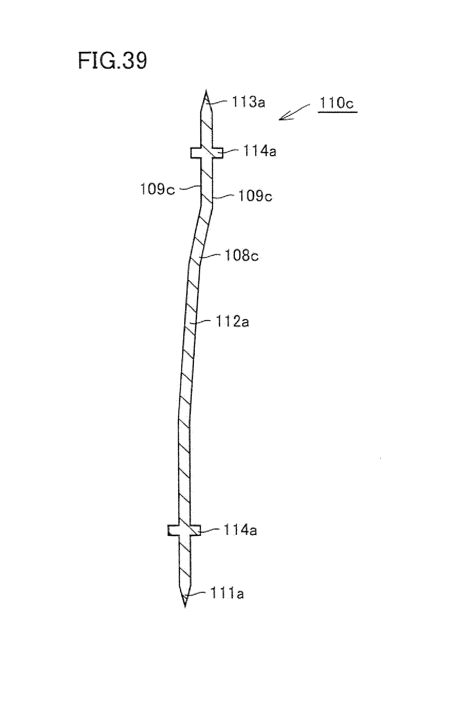

Fig. 39 is a plan view schematically showing contact probe 110c of a ninth embodiment of the present invention. Referring to Fig. 39, contact probe 110c in the present embodiment will be described. Contact probe 110c in the present embodiment basically has the same configuration as that of contact probe 110a of the seventh embodiment shown in Fig. 34. Contact probe 110c of the present embodiment is, however, different in that metal layer 108c is formed on contact probe 110a. Contact probe 110c of the present embodiment is fabricated using linked body of contact probes 101c of the eighth embodiment shown in Figs. 36 and 37.

Contact probe 110c has metal layer 108c formed in all regions except an area 109c which was in contact with holding portion 105a in Fig. 36. That is, 99 % or more of the surface area of contact probe 110c is covered with metal layer 108c.

Metal layer 108c has a thickness of, for example, not less than 0.5 µm and not more than 10 µm. With a thickness within this range, properties of the plurality of contact probes 110a can be improved. When metal layer 108c has a thickness within the above-indicated range, for instance, metal layer 108c formed of Rh can improve abrasion resistance, metal layer 108c formed of Rh or PdCo can reduce contact resistance, and metal layer 108c formed of Cu or Au can improve allowable current value.

A method of manufacturing contact probe 110c in the present embodiment will be described in the following. First, linked body of contact probes 101c in the eighth embodiment is manufactured.

Next, contact probe 11 1c is separated from linking member 102c in linked body of contact probes 101c. The method of the separation is the same as that in the seventh embodiment, and therefore, the description thereof will not be repeated.

As described above, according to contact probe 110c and the manufacturing method thereof in the present embodiment, by separating contact probe 110c after plating the entire linked body of contact probes 101c, contact probe 110c plated without individually plating contact probe 110c is realized. As a result, as compared with a case where contact probes are individually plated, easy handling can be provided and cost reduction can be achieved.

Further, although a region for gripping a contact probe cannot be plated in the case where contact probes are individually plated, by gripping grip portion 106a of linked body of contact probes 101c for plating as in the present embodiment, an unplated region in contact probe 110c (only area 109c which was in contact with linking member 102c) can be reduced. Further, contact probe 110c can be uniformly plated. Therefore, contact probe 110c with improved performance can be realized.

### Tenth Embodiment: Linked Body of Contact Probes

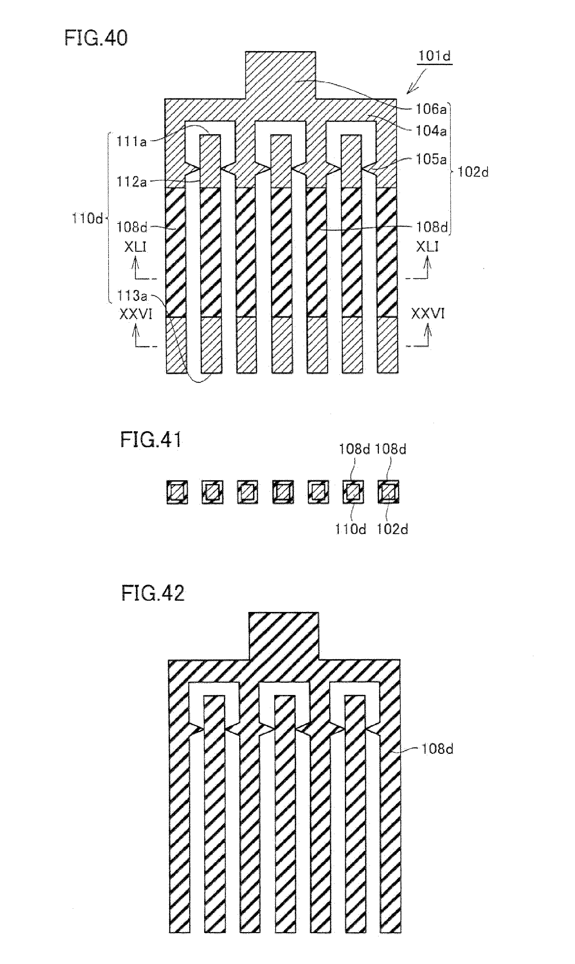

Fig. 40 is a plan view schematically showing a linked body of contact probes 101d in a tenth embodiment of the present invention. Fig. 41 is a cross sectional view along a line XLI-XLI in Fig. 40. A cross sectional view along a line XXVI-XXVI in Fig. 40 is the same as Fig. 26. With reference to Figs. 26, 40 and 41, linked body of contact probes 101d in the present embodiment will be described.

Linked body of contact probes 101d in the present embodiment basically has the same configuration as that of linked body of contact probes 101a in the fifth embodiment shown in Figs. 25 and 26. Linked body of contact probes 101d of the present embodiment is, however, different in that an insulating layer 108d which covers part of linked body of contact probes 101a is further formed.

Insulating layer 108d of the present embodiment partly covers linked body of contact probes 101 a in its middle. That is, insulating layer 108d is not formed on contact portions 111a and tip portions 113a of a plurality of contact probes 110d. In other words, insulating layer 108d is formed in a region located in parallel with main body portion 112a in a linking member 102d, and on main body portion 112a. For insulating layer 108d, for example, an organic film such as a parylene resin can be used, and an organic material having a thin film thickness is suitably used.

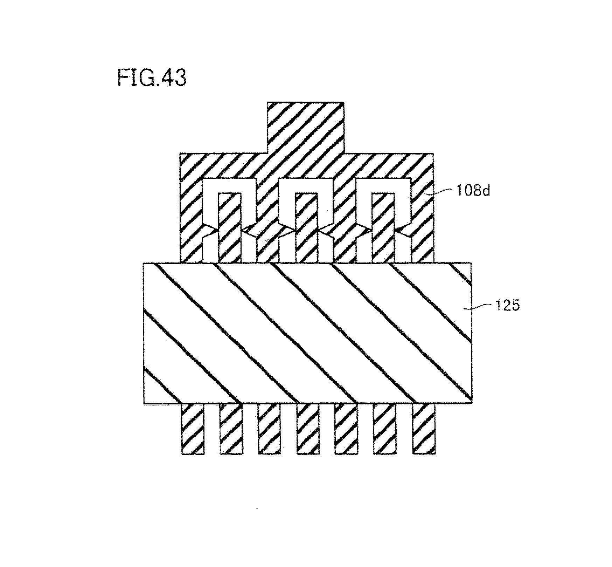

A method of manufacturing linked body of contact probes 101d in the present embodiment will be described in the following with reference to Figs. 40 to 43. It is noted that Figs. 42 and 43 are plan views each showing a step for manufacturing the linked body of contact probes in the present embodiment. First, linked body of contact probes 101a of the fifth embodiment is manufactured.

Next, as shown in Fig. 42, insulating layer 108d is formed on the entire surface of linked body of contact probes 101a. A method of forming insulating layer 108d is not particularly limited, and, for example, a coating method employing a CVD (Chemical Vapor Deposition) method can be used. Subsequently, as shown in Fig. 43, a mask layer 125 is formed on a region where insulating layer 108d should be formed. Mask layer 125 forms on the region where insulating layer 108d should be formed.

For a region exposed out of mask layer 125, RIE (Reactive Ion Etching) or ashing using, for example, a mixed gas of carbon tetrafluoride (CF₄) and oxygen (O₂) follows. As a result, insulating layer 108d in the region exposed out of mask layer 125 can be removed to expose a metal material that constitutes linked body of contact probes 101a.

It is noted that instead of mask layer 125, a metal mask may be used. In this case, the metal mask is placed in a manner to cover the region where insulating layer 108d should be formed.

Linked body of contact probes 101d on which insulating layer 108d is partly formed as shown in Figs. 40 and 41 can be manufactured by carrying out the steps above.

According to linked body of contact probes 101d and the manufacturing method thereof of the present embodiment, formation of insulating layer 108d and removal of unnecessary areas is performed in a state of linked body of contact probes 101d including the plurality of contact probes 110d. The present embodiment does not require that contact probe 110d be individually gripped, and therefore, as compared with a case where insulating layer 108d is individually formed, insulating layer 108d can be readily formed. Further, linking member 102d allows for easy positioning in forming mask layer 125. Therefore, in an aftertreatment such as insulative coating, easy handling is provided, and cost reduction can be achieved.

Further, formation of insulating layer 108d can suppress shorting of each of the plurality of contact probes 110d even if they are arranged at a high density.

### Eleventh Embodiment: Contact Probe

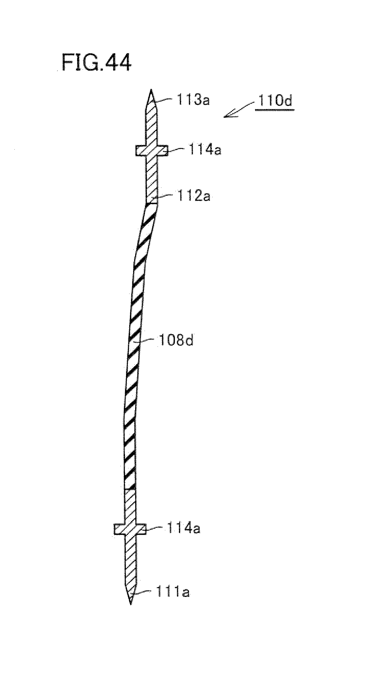

Fig. 44 is a plan view schematically showing contact probe 110d of an eleventh embodiment of the present invention. Referring to Fig. 44, contact probe 110d in the present embodiment will be described. Contact probe 110d in the present embodiment basically has the same configuration as that of contact probe 110a in the seventh embodiment shown in Fig. 34. Contact probe 110d of the present embodiment is, however, different in that insulating layer 108d is formed on part of contact probe 110a. Contact probe 110d of the present embodiment is fabricated using linked body of contact probes 101d of the tenth embodiment shown in Figs. 40 and 41.

On contact probe 110d, insulating layer 108d is partly formed as shown in Fig. 44. In the present embodiment, part of main body portion 112a is covered with insulating layer 108d.

A method of manufacturing contact probe 110d in the present embodiment will be described in the following. First, linked body of contact probes 101d in the tenth embodiment is manufactured.

Next, contact probe 110d is separated from linking member 102c in linked body of contact probes 101d. The method for the separation is the same as that in the seventh embodiment, and therefore, the description thereof will not be repeated.

As described above, according to contact probe 110d and the manufacturing method thereof in the present embodiment, insulating layer 108d is formed on linked body of contact probes 101d and part of insulating layer 108d is removed. As a result, contact probe 110d on which insulating layer 108d is partly formed can be realized without individually performing the step of forming insulating layer 108d on contact probe 110d. Therefore, easy handling can be provided, and reduction of costs can be achieved.

### EXAMPLES

In the present example, a study was made of an effect of the provision of a covering portion which covers the whole outer circumference of a cross section of a main body portion in a direction intersecting with an extensional direction, excluding a contact portion, and has a lower volume resistivity than the volume resistivity of the main body portion.

### Example 1 of the Present Invention

Specifically, contact probe 10b shown in Fig. 22 is manufactured in accordance with the above-described method of manufacturing contact probe 10b of the third embodiment.

First, as shown in Figs. 3 and 4, lithography is performed on an SUS substrate as conductive substrate 21, thereby forming mold 22 having opening 22a and made of a resist resin as the resin. Opening 22a has a shape open for region R1 to form contact probes each having a shape of contact probe 10b of Fig. 22 on which covering portion 14 has not been formed and for region R2 to form a linking member linking the plurality of contact probes. Region R1 to form contact probes is formed to provide not less than one hundred contact probes. Region R2 to form linking member 2 is formed to have, for ease of disconnection, thickness H1 in Fig. 4 of 70 µm, as well as L1 of 10-20 µm, L2 of 10-20 µm, L3 of 10-20 µm, L4 of 10 µm, L5 of 100 µm, L6 of 60 µm, and L7 of 60 µm, all in Fig. 9.

Next, as shown in Figs. 5 and 6, opening 22a of mold 22 is plated with a nickel manganese alloy and polished to have thickness H2 of 60 µm.

Next, mold 22 is removed, and a fine metal part is taken out of substrate 21, thereby fabricating linked body of contact probes 1a in which not less than one hundred contact probes are interlinked through the linking member, as shown in Fig. 7.

Next, as shown in Fig. 12, the entire surface of linked body of contact probes 1a is coated with parylene as insulating layer 18. Next, as shown in Fig. 13, areas other than areas where covering portions 14 are to be formed are covered with mask layer 25 to perform ashing using a mixed gas of CF₄ and O₂. As a result, as shown in Fig. 14, insulating layer 18 in a region where covering portion 14 is to be formed is removed.

Next, as shown in Fig. 15, copper plating is performed by electrolytic plating. At this time, the positive poles are arranged on the front and the back, respectively, so that a uniform thickness can be obtained. As a result, as shown in Figs. 16 and 17, a copper plating layer having a thickness of 4 µm is formed in a manner to cover the whole circumference of the middle portion of main body portion 12. This copper plating layer serves as covering portion 14.

Subsequently, as shown in Fig. 18, ashing is performed, and parylene is entirely removed. Finally, linking member 2 of linked body of contact probes 1c shown in Fig. 18 is disconnected by fixing linking member 2 and pulling the tip of contact probe 10b as shown in Fig. 19, and contact probe 10b is made into an individual piece.

### Comparative Example 1

A contact probe of Comparative Example 1 is manufactured in the same manner as that of Example 1 of the present invention but differs in that no covering portion is formed. Specifically, linked body of contact probes 1a shown in Fig. 7 is fabricated, followed by disconnection of linking member 2 in the same method as that in Example 1 of the present invention to make the contact probe into an individual piece.

### Comparative Example 2

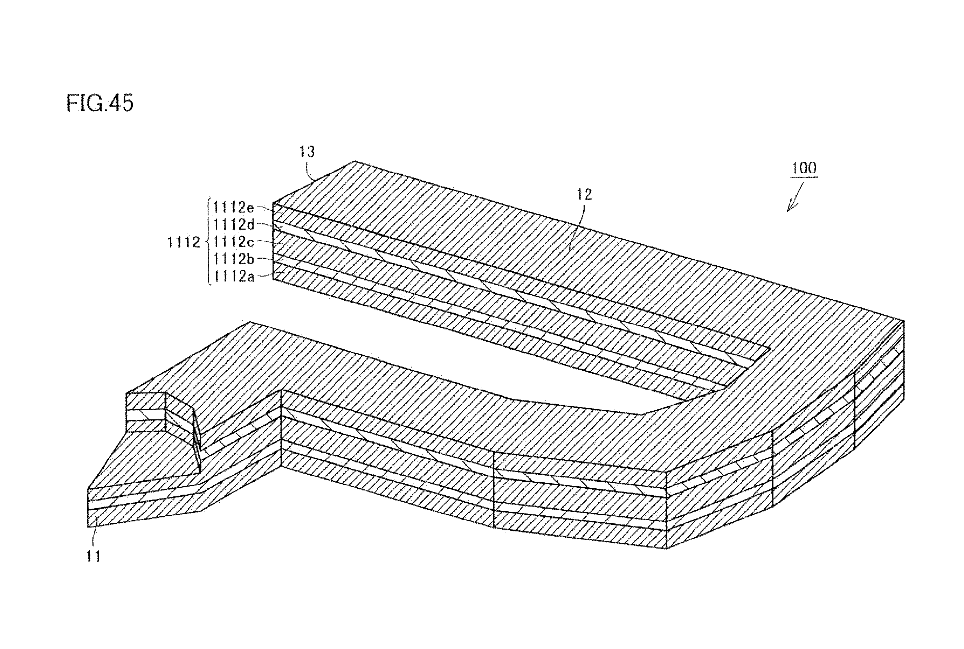

A contact probe of Comparative Example 2 has a nickel manganese alloy layer 1112a, a rhodium plating layer 1112b, a nickel manganese alloy layer 1112c, a copper plating layer 1112d, and a nickel manganese alloy layer 1112e, which are laminated in this order as shown in Fig. 45. It is noted that Fig. 45 is a perspective view schematically showing the contact probe of Comparative Example 2.

### Measurement Result

A study of properties of contact probes of Example 1 of the present invention, Comparative Example 1, and Comparative Example 2 showed that the contact probe of Example 1 of the present invention has a large constant of spring as compared with that of the contact probe of Comparative Example 1, yet is still capable of serving as a contact probe and has an allowable current value allowing a current of not less than 1A to flow through. The allowable current value in Example 1 of the present invention was a value similar to that of the contact probe of Comparative Example 2.

Further, it was understood that the contact probe of Example 1 of the present invention can be repetitively used without a copper plated portion's coming off and allows for stable use as compared with the contact probe of Comparative Example 2 shown in Fig. 45 in which metal layers are laminated.

Though the embodiments and the example of the present invention have been described as above, combination of features in each embodiment and example as appropriate is originally intended. It should be understood that the embodiments and the example disclosed herein are illustrative and non-restrictive in every respect. The scope of the present invention is defined by the terms of the claims, rather than the embodiments and example above, and is intended to include any modifications within the scope and meaning equivalent to the terms of the claims.

### INDUSTRIAL APPLICABILITY

The present invention is advantageously applied in particular to a contact probe used for measurement of electrical properties of an electrical circuit or the like.

### REFERENCE SIGNS LIST

1a, 1b, 1c, 1d linked body of contact probes; 2 linking member; 3 separating portion; 4, 7 connecting portion; 5 holding portion; 6 grip portion; 10a, 10b contact probe; 11 contact portion; 12 main body portion; 13 tip portion; 14 covering portion; 15 stopper; 18 insulating layer; 21 substrate; 22 mold; 22a opening; 23 plating solution; 24 power supply; 25 mask layer; 26 electrode; 27 container; 28 etchant; 101a, 101b, 101c, 101d linked body of contact probes; 102a, 102b, 102c, 102d linking member; 103a separating portion; 104a, 107b connecting portion; 105a holding portion; 106a grip portion; 108c metal layer; 108d insulating layer; 109c area; 110a, 110b, 110c, 110d contact probe; 111a contact portion; 112a main body portion; 113a tip portion; 114a stopper; 121 substrate; 122 mold; 122a opening; 123 plating solution; 124 power supply; 125 mask layer; 126 electrode.

## Claims

1. A contact probe (10a, 10b) comprising:
a contact portion (11) to be brought into contact with an object to be measured;
a main body portion (12) connected to said contact portion (11); and
a covering portion (14) covering the whole outer circumference of a cross section of said main body portion (12) in a direction intersecting with an extensional direction, excluding said contact portion (11),
said covering portion (14) being of a material having a lower volume resistivity than a volume resistivity of a material of said main body portion (12).

2. The contact probe (10a, 10b) according to claim 1, wherein
said main body portion (12) is of a nickel alloy.

3. A linked body of contact probes, comprising:
the plurality of contact probes (10a) according to claim 1; and
a linking member (2) linking said plurality of contact probes (10a) together in areas in said plurality of contact probes (10a) other than said contact portion (11) and a tip portion (13) opposite said contact portion.

4. A method of manufacturing a linked body of contact probes, comprising the steps of:
forming, on a substrate (21), a resin mold (22) having an opening (22a);
filling said opening (22a) of said mold (22) with a metal material by electroforming;
forming a contact portion (11) to be brought into contact with an object to be measured, a main body portion (12) connected to said contact portion (11), and tip portion (13) located opposite said contact portion (11) in said main body portion (12), by removing said mold (22) and said substrate (21); and
forming a covering portion (14) to cover the whole outer circumference of a cross section of said main body portion (12) in a direction intersecting with an extensional direction, excluding said contact portion (11), with a material having a lower volume resistivity than a volume resistivity of said main body portion (12),
in said step of forming said mold (22), said opening (22a) open for a region to form a plurality of contact probes (10a, 10b) each including said contact portion (11), said main body portion (12), and said tip portion (13) and for a region to form a linking member (2) linking said plurality of contact probes (10a, 10b) together in areas in said plurality of contact probes (10a, 10b) other than said contact portion (11) and said tip portion (13) being formed.

5. The method of manufacturing a linked body of contact probes according to claim 4, wherein
said step of forming said covering portion (14) includes the steps of:
forming a metal layer by covering said main body portion (12) with the material to form said covering portion (14); and
removing a region in said metal layer other than a region to serve as said covering portion (14).

6. The method of manufacturing a linked body of contact probes according to claim 4, wherein
said step of forming said covering portion (14) includes the steps of:
covering said main body portion (12) with an insulating layer (18);
exposing said main body portion (12) by removing a region where said covering portion (14) is to be formed in said insulating layer (18); and
forming said covering portion (14) on exposed said main body portion (12).

7. A method of manufacturing a contact probe, comprising the steps of:
manufacturing a linked body of contact probes (1c) by the method of manufacturing a linked body of contact probes according to claim 4; and
separating said contact probe (10a, 10b) from a link in said linked body of contact probes (1c).

8. A linked body of contact probes (101a-101d), comprising:
a plurality of contact probes (110a-110d) each including a contact portion (111a) to be brought into contact with an object to be measured and a tip portion (113a) opposite said contact portion (111a); and
a linking member (102a-102d) linking said plurality of contact probes (110a-110d) together in areas in said plurality of contact probes (110a-110d) other than said contact portion (111a) and said tip portion (113a).

9. The linked body of contact probes (101a-101d) according to claim 8,
wherein
said linking member (102a-102d) includes holding portions (105a) holding at least two points of the outer circumference of each of said plurality of contact probes (110a-110d) along one direction intersecting with a direction along which said plurality of contact probes (110a-110d) extend.

10. The linked body of contact probes (101a-101d) according to claim 8,
wherein
said linking member (102a-102d) includes a plurality of separating portions (103a) arranged spaced from each other in parallel and a first connecting portion (104a) linking one end of each of said plurality of separating portions (103a) together,
each of said plurality of contact probes (110a-110d) is arranged between corresponding separating portions of said plurality of separating portions (103a), and each of said contact portions (111a) or said tip portions (113a) opposed to said first connecting portion (104a) is arranged spaced from said first connecting portion (104a).

11. The linked body of contact probes (101a-101d) according to claim 10,
wherein
said linking member (102a-102d) further includes a second connecting portion (107b) linking another end of each of said plurality of separating portions (103a) together and arranged spaced from said contact portions (111a) or said tip portions (113a) of opposed said plurality of contact probes (110a-110d).

12. A method of manufacturing a linked body of contact probes, comprising the steps of:
forming, on a substrate (121), a resin mold (122) having an opening (122a);
filling said opening (122a) of said mold (122) with a metal material by electroforming; and
removing said mold (122) and said substrate (121),
in said step of forming said mold (122), said opening (122a) open for a region to form a plurality of contact probes (110a-110d) each including a contact portion (111a) to be brought into contact with an object to be measured and a tip portion (113a) opposite said contact portion (111a) and for a region to form a linking member (102a-102d) linking said plurality of contact probes (110a-110d) together in areas in said plurality of contact probes (110a-110d) other than said contact portion (111a) and said tip portion (113a) being formed.

13. The method of manufacturing a linked body of contact probes according to claim 12, wherein
in said step of forming said mold (122), said opening (122a) is formed such that said linking member (102a-102d) includes holding portions (105a) holding at least two points of the outer circumference of each of said plurality of contact probes (110a-110d) along one direction intersecting with a direction along which said plurality of contact probes (110a-110d) extend.

14. The method of manufacturing a linked body of contact probes according to claim 12, wherein
in said step of forming said mold (122), said opening (122a) is formed such that said linking member (102a-102d) includes a plurality of separating portions (103a) arranged spaced from each other in parallel and a first connecting portion (104a) linking one end of each of said plurality of separating portions (103 a) together; that each of said plurality of contact probes (110a-110d) is arranged between corresponding separating portions of said plurality of separating portions (103a); and that each of said contact portions (111a) or said tip portions (113a) opposed to said first connecting portion (104a) is arranged spaced from said first connecting portion (104a).

15. The method of manufacturing a linked body of contact probes according to claim 14, wherein
in said step of forming said mold (122), said opening (122a) is formed such that said linking member (102a-102d) further includes a second connecting portion (107b) linking another end of each of said plurality of separating portions (103a) together and arranged spaced from said contact portions (111a) or said tip portions (113a) of opposed said plurality of contact probes (110a-110d).

16. A method of manufacturing a contact probe, comprising the steps of:
manufacturing a linked body of contact probes (101a-101d) by the method of manufacturing a linked body of contact probes according to claim 12; and
separating said contact probe (110a-110d) and said linking member (102a-102d) from each other in said linked body of contact probes (101a-101d).
